(19) Europäisches Patentamt
European Patent Office
Office européen des brevets

(11) **EP 2 841 264 B1**

(12) **FASCICULE DE BREVET EUROPEEN**

(45) Date de publication et mention
de la délivrance du brevet:
**24.01.2024 Bulletin 2024/04**

(21) Numéro de dépôt: **13722497.8**

(22) Date de dépôt: **17.04.2013**

(51) Classification Internationale des Brevets (IPC):
**B32B 15/01** (2006.01)   **C23C 14/16** (2006.01)
**C23C 14/35** (2006.01)   **C23C 28/02** (2006.01)
**G21C 3/07** (2006.01)    **G21C 3/20** (2006.01)

(52) Classification Coopérative des Brevets (CPC):
**B32B 15/01; C23C 28/02; C23C 28/021;
C23C 28/023; G21C 3/07; G21C 3/20;** Y02E 30/30

(86) Numéro de dépôt international:
**PCT/FR2013/050849**

(87) Numéro de publication internationale:
**WO 2013/160587 (31.10.2013 Gazette 2013/44)**

(54) **MATERIAU MULTICOUCHE RESISTANT A L'OXYDATION EN MILIEU NUCLEAIRE**

MEHRSCHICHTIGES GEGEN OXIDATION IN EINER NUKLEAREN UMGEBUNG RESISTENTES MATERIAL

MULTILAYER MATERIAL RESISTANT TO OXIDATION IN A NUCLEAR ENVIRONMENT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.04.2012 FR 1253887**

(43) Date de publication de la demande:
**04.03.2015 Bulletin 2015/10**

(73) Titulaire: **Commissariat à l'Énergie Atomique
et aux Énergies Alternatives
75015 Paris (FR)**

(72) Inventeurs:
• **LE FLEM, Marion
92260 Fontenay Aux Roses (FR)**
• **DUCROS, Cédric
38690 Bevenais (FR)**
• **SANCHETTE, Frédéric
38620 Montferrat (FR)**

(74) Mandataire: **Dennemeyer & Associates S.A.
Postfach 70 04 25
81304 München (DE)**

(56) Documents cités:
EP-A1- 0 240 110   WO-A1-2006/038826
FR-A- 1 493 040   FR-A- 1 493 040
FR-A- 1 493 040   FR-A1- 2 849 620
GB-A- 1 203 700   GB-A- 1 203 700
JP-A- H05 171 418   US-A- 5 962 115
US-A- 5 962 115

• KIM J H ET AL: "Performance of a diffusion barrier under a fuel-clad chemical interaction (FCCI)", JOURNAL OF NUCLEAR MATERIALS, ELSEVIER B.V, NETHERLANDS, vol. 394, no. 2-3, 1 novembre 2009 (2009-11-01), pages 144-150, XP026751827, ISSN: 0022-3115, DOI: 10.1016/J.JNUCMAT.2009.08.018 [extrait le 2009-09-04]
• DATABASE WPI Week 200628 Thomson Scientific, London, GB; AN 2006-273053 XP002784754, & WO 2006/038826 A1 (PADEROV A N) 13 avril 2006 (2006-04-13) -& WO 2006/038826 A1 (PADEROV ANATOLY NIKOLAEVICH [RU]; VEKSLER YURI GENRIHOVICH [RU]) 13 avril 2006 (2006-04-13)
• KIM J H ET AL: "Performance of a diffusion barrier under a fuel-clad chemical interaction (FCCI)", JOURNAL OF NUCLEAR MATERIALS, ELSEVIER BV, NL, vol. 394, no. 2-3, 1 novembre 2009 (2009-11-01), pages 144-150, XP026751827, ISSN: 0022-3115, DOI: 10.1016/J.JNUCMAT.2009.08.018 [extrait le 2009-09-04]

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

- DATABASE WPI Week 201101 1 janvier 2011 (2011-01-01) Thomson Scientific, London, GB; AN 2010-N85039 XP002690390, -& KR 2010 0114392 A (KOREA ATOMIC ENERGY RES INST) 25 octobre 2010 (2010-10-25)
- DAVIDSON ET AL: "The effects on fracture toughness of ductile-phase composition and morphology in Nb-Cr-Ti and Nb-Siin situ composites", METALLURGICAL AND MATERIALS TRANSACTIONS A: PHYSICAL METALLURGY & MATERIALS SCIENCE, ASM INTERNATIONAL, MATERIALS PARK, OH, US, vol. 27, no. 10, 1 octobre 1996 (1996-10-01), pages 3007-3018, XP008159323, ISSN: 1073-5623, DOI: 10.1007/BF02663850 [extrait le 2007-07-13]
- KIM J H ET AL: "Performance of a diffusion barrier under a fuel-clad chemical interaction (FCCI)", JOURNAL OF NUCLEAR MATERIALS, ELSEVIER B.V, NETHERLANDS, vol. 394, no. 2-3, 1 November 2009 (2009-11-01), pages 144-150, XP026751827, ISSN: 0022-3115, DOI: 10.1016/J.JNUCMAT.2009.08.018 [retrieved on 2009-09-04]

**Description**

**DOMAINE TECHNIQUE**

La présente invention appartient au domaine des matériaux mis en oeuvre dans le domaine nucléaire, en particulier les matériaux destinés à résister au mieux aux conditions physico-chimiques rencontrées lors d'un accident de réacteur nucléaire.

L'invention concerne plus particulièrement un tel matériau, une pièce comprenant le matériau ainsi que le procédé de fabrication du matériau.

**ARRIERE-PLAN TECHNIQUE**

En conditions de service, le caloporteur d'un Réacteur nucléaire à Eau sous Pression (« REP ») est une eau qui est pressurisée à 190 bars et atteint une température maximale de 360 °C.

Dans de telles conditions, l'alliage de zirconium constitutif des gaines de combustible nucléaire s'oxyde au contact du caloporteur.

L'oxyde formé étant fragile, la durée de vie des gaines est en partie limitée par l'épaisseur maximale d'oxyde acceptable. Au-delà, l'épaisseur résiduelle d'alliage de zirconium sain et ductile est insuffisante pour garantir de bonnes propriétés mécaniques visant à assurer un confinement optimal du combustible nucléaire.

Limiter l'oxydation en conditions nominales permettrait donc d'augmenter la durée de vie des gaines et donc d'améliorer le taux de combustion du dioxyde d'uranium.

Dans ce but, les industriels fournisseurs de combustible ont développé de nouveaux alliages plus résistants à la corrosion en conditions nominales, tels que l'alliage M5™ de la société Areva-NP.

Si ces développements ont permis d'améliorer la résistance des gaines en alliage de zirconium vis-à-vis de l'oxydation à basse température rencontrée en conditions nominales, ils n'apportent pas de gains déterminants dans la résistance à l'oxydation à haute température rencontrée en conditions accidentelles.

Les hautes températures sont généralement supérieures à 700 °C, en particulier comprises entre 800 °C et 1200 °C. Elles sont par exemple atteintes dans le cas de scénarios hypothétiques accidentels type « RIA » (pour "Reactivity Insertion Accident") ou « APRP » (Accident de Perte de Réfrigérant Primaire), voire en conditions de dénoyage de la piscine de stockage de combustible usé. À de telles températures, le caloporteur se présente sous forme de vapeur d'eau.

Comme détaillé ci-après, l'oxydation à haute température est beaucoup plus critique qu'à basse température, car la détérioration du gainage, première barrière de confinement du combustible, est plus rapide et les risques associés plus importants. Ces risques sont notamment les suivants :

- dégagement d'hydrogène ;
- fragilisation du gainage à haute température, par l'oxydation voire, dans certaines conditions, l'hydruration du gainage ;
- fragilisation du gainage à la trempe, provoquée par la diminution brutale de température lors de l'apport massif d'eau pour la mise en sécurité du coeur du réacteur nucléaire ;
- faible tenue mécanique du gainage après la trempe ou le refroidissement, en cas notamment d'opérations de manutention après accident.

Compte tenu de ces risques, il est donc essentiel de limiter au mieux l'oxydation à haute température du gainage afin d'améliorer la sûreté des réacteurs nucléaires utilisant notamment l'eau comme caloporteur.

Des études visent à améliorer la résistance à l'oxydation d'alliage de zirconium soumis à une température supérieure à celle rencontrée en conditions de service. Toutefois, les températures rencontrées en conditions accidentelles ne sont pas prises en compte.

Le document « FR 1493040 A » propose ainsi de revêtir un alliage de zirconium avec une couche de chrome. Ce revêtement monocouche est présenté comme permettant de protéger l'alliage de zirconium vis-à-vis de l'oxydation à une température de 600 °C, à pression atmosphérique et dans le gaz carbonique. Toutefois, comme démontré expérimentalement ci-après, le revêtement proposé ne réussit pas à limiter significativement l'oxydation à haute température.

Il est en outre à noter que les conditions testées ne permettent en aucun cas de prévoir la résistance à la corrosion de l'alliage de zirconium à une température supérieure à 600 °C.

Cette absence de prédictibilité est due au fait que la recherche de solutions contre l'oxydation en conditions accidentelles nécessite d'explorer un nouveau champ de recherche. En effet, comme détaillé ci-après, les conditions physico-chimiques et les mécanismes de l'oxydation à haute température sont fondamentalement différents de ceux d'une oxydation à une température inférieure ou égale à 600 °C.

## EXPOSE DE L'INVENTION

Un des buts de l'invention est donc d'éviter, d'atténuer et/ou de retarder les inconvénients décrits ci-dessus, en proposant un matériau qui puisse notamment apporter une résistance significativement améliorée vis-à-vis de l'oxydation en conditions accidentelles d'une gaine de combustible nucléaire à base de zirconium, tout en préservant voire en améliorant la résistance à l'oxydation de cette gaine en conditions de service.

Un autre but de l'invention est d'améliorer les propriétés mécaniques du matériau, notamment sa ductilité et sa résistance mécanique, suite à une oxydation en conditions accidentelles.

Un autre but de l'invention est de diminuer la production d'hydrogène gazeux (risque hydrogène) ou d'hydrogène diffusant dans le gainage (fragilisation par hydruration).

La présente invention concerne ainsi un matériau multicouche suivant les revendications.

Dans la présente description de l'invention, sauf indication contraire, les pourcentages de composition sont exprimés en pourcentage atomique.

Par ailleurs, les matières métalliques citées ci-après (notamment le zirconium, le chrome ou leurs alliages, et/ou l'alliage ternaire du système Nb-Cr-Ti) peuvent contenir des impuretés inévitables de fabrication. La nature et les teneurs de ces impuretés sont généralement les natures et teneurs typiques des impuretés des matières métalliques industrielles utilisées notamment dans le domaine nucléaire et donc compatibles en particulier avec les exigences du cahier des charges de cette industrie. Généralement, les teneurs des impuretés inévitables sont de moins de 200 ppm, préférentiellement moins de 100 ppm, encore plus préférentiellement moins de 50 ppm.

Enfin, un verbe tel que « comprendre », « comporter », « incorporer », « inclure » et ses formes conjuguées sont des termes ouverts et n'excluent donc pas la présence d'élément(s) et/ou étape(s) additionnels s'ajoutant aux élément(s) et/ou étape(s) initiaux énoncés après ces termes. Toutefois, ces termes ouverts visent en outre un mode de réalisation particulier dans lequel seul(s) le(s) élément(s) et/ou étape(s) initiaux, à l'exclusion de tout autre, sont visés ; auquel cas le terme ouvert vise en outre le terme fermé « consister en », « constituer de » et ses formes conjuguées.

Ainsi, le matériau multicouche de l'invention peut comprendre un substrat à base de zirconium recouvert d'un revêtement multicouche, comme indiqué dans les revendications, le revêtement multicouche consistant en les couches métalliques composées de matières identiques ou différentes choisies parmi le chrome, un alliage de chrome ou un alliage ternaire du système Nb-Cr-Ti.

Contrairement aux matériaux de l'état de la technique, le matériau multicouche de l'invention ne subit qu'une oxydation limitée lors de l'accident d'un réacteur nucléaire, dont les conditions se caractérisent notamment par des températures supérieures à 700 °C, typiquement comprises entre 700 °C et 1200 °C, voire le cas échéant comprises entre 800 °C et 1200 °C ou entre 1000 °C et 1200 °C. Cette résistance à l'oxydation permet notamment de limiter le dégagement ou la prise d'hydrogène et de réduire la fragilité d'une pièce composée en tout ou partie de ce matériau, telle que par exemple une gaine de combustible nucléaire.

De tels résultats ont pu être obtenus malgré la présence de phénomènes physico-chimiques et de structures du zirconium, qui sont propres aux conditions accidentelles et ne permettent donc pas de s'appuyer sur les solutions existant en conditions de service. Ces phénomènes physico-chimiques et structures du zirconium sont détaillés ci-après pour un alliage de zirconium, tout en étant transposables au zirconium en tant que tel.

Lors d'une situation accidentelle, l'alliage de zirconium constitutif des gaines de combustible nucléaire subit une série de transformations dues non seulement aux températures supérieures à 700 °C (voire supérieures à 800 °C ou supérieures à 1000 °C), mais aussi à la diffusion de l'oxygène dans l'alliage. Les conditions spécifiques qui en résultent sont notamment les suivantes :

- <u>hydruration</u> : il s'agit d'un phénomène se produisant au sein d'une gaine de combustible nucléaire en conditions nominales ou dans certaines conditions accidentelles. L'hydruration résulte de la succession des réactions (1) et (2) suivantes : le zirconium contenu dans la gaine de combustible nucléaire est oxydé par l'eau pressurisée ou la vapeur d'eau selon la réaction

$$(1) \ Zr + 2H_2O \rightarrow ZrO_2 + 2H_2$$

, puis l'hydrogène ainsi libéré diffuse dans l'alliage de zirconium de la gaine et peut former un hydrure avec le zirconium non encore oxydé de la gaine selon la réaction

$$(2) \ Zr + xH \rightarrow ZrH_x.$$

L'indice « x » indique que des hydrures de stoechiométrie variable peuvent être formés, cet indice étant en particulier égal à 2.

Selon la teneur globale en hydrogène et/ou la température, tout ou partie de l'hydrogène va précipiter, le reste restant en solution solide (en insertion dans le réseau cristallin zirconium-alpha).

Par exemple, à 20 °C, la quasi-totalité de l'hydrogène est précipitée sous forme d'hydrures alors que leur dissolution peut être totale à haute température (typiquement supérieure à 600 °C).

L'hydrogène en solution solide, mais surtout sous forme de précipité d'hydrure de zirconium, a pour inconvénient de diminuer la ductilité des alliages de zirconium, et donc de fragiliser la gaine, notamment à basse température. Cette fragilisation est d'autant plus à craindre lorsque l'on cherche à atteindre de forts taux de combustion car, à ces taux, on constate un accroissement de la proportion de zirconium oxydé selon la réaction (1) et donc de la quantité d'hydrures formés selon la réaction (2). Elle conduit alors le plus souvent à la corrosion des alliages industriels usuels à des niveaux rédhibitoires vis-à-vis des critères de sûreté et d'intégrité de la gaine, et pose des problèmes pour le transport et l'entreposage post-service.

Observée en conditions nominales, l'hydruration n'est généralement observée en conditions accidentelles qu'au voisinage de 1000 °C. Ce phénomène, appelé « breakaway » et associé à une augmentation de la cinétique d'oxydation, n'est à ce jour pas clairement explicite. Il résulte de l'apparition de fissures et/ou de porosités dans la phase $ZrO_2$ liées à la présence de contraintes générées à l'interface $Zr/ZrO_2$ probablement liée à la transformation réversible de $ZrO_2$ quadratique en $ZrO_2$ monoclinique. Les conséquences de cette prise d'hydrogène sont, de la même manière qu'en conditions nominales, une fragilisation du matériau au voisinage de 1000 °C pouvant conduire à sa rupture lors d'une trempe ou après un retour à basse température.

- dégagement d'hydrogène : la corrosion aqueuse à la surface de l'alliage de zirconium conduit généralement à la dissociation de la molécule d'eau. La production d'hydrogène radicalaire qui en résulte mène à l'hydruration de l'alliage de zirconium. Or, pour des conditions typiques de l'APRP que sont l'exposition à des températures au-delà de 1050 °C pendant 15 à 30 minutes, cette hydruration est remplacée par un fort dégagement d'hydrogène moléculaire ($H_2$).

- structure « Zr-$\beta$ » : la phase $\alpha$ d'un alliage de zirconium (notée « Zr-$\alpha$ », de structure cristallographique hexagonale compacte) à basse température se transforme en phase $\beta$ (notée « Zr-$\beta$ », de structure cristallographique cubique centrée) dans une gamme de température allant typiquement de 700 °C à 1000 °C et variant selon l'alliage, la vitesse de chauffage, la teneur en hydrogène $H_2$...

En passant de la structure Zr-$\alpha$ à la structure cubique Zr-$\beta$, l'alliage subit des variations dimensionnelles locales.

Ces variations sont a priori défavorables à la tenue mécanique d'un revêtement qui recouvrirait un substrat à base de zirconium, en raison notamment de l'incompatibilité de leurs coefficients de dilatation.

Ces difficultés d'adhérence sont accentuées par les mécanismes de diffusion d'espèces chimiques qui sont plus rapides dans la phase Zr-$\beta$ que dans la phase Zr-$\alpha$, et qui peuvent modifier l'interface entre le substrat et son revêtement.

- formation de « Zr-$\alpha$ (O) » : l'accélération de la diffusion a également pour conséquence, qu'après formation d'une couche externe de $ZrO_2$ en surface de l'alliage de zirconium, l'oxygène poursuit sa progression dans la phase Zr-$\beta$ saine, contrairement à ce qui se passe en conditions de service.

L'oxydation se poursuit alors sous la couche externe de $ZrO_2$ jusqu'à ce que l'oxygène atteigne sa limite de solubilité qui est relativement faible dans le Zr-$\beta$, typiquement inférieure à 1 % massique à 1100 °C.

Le Zr-$\beta$ se transforme alors en solution solide Zr-$\alpha$(O) qui peut contenir entre 2 % et 7 % massique d'oxygène en solution solide, alors que seul du $ZrO_2$ est formé à basse température.

Lors de l'oxydation d'un alliage de zirconium à une température supérieure à 1000 °C, il y a donc coexistence de trois couches : $ZrO_2$, Zr-$\alpha$ (O) et Zr-$\beta$.

Après renoyage du coeur lors de l'activation des systèmes de sûreté du réacteur nucléaire, les gaines de combustibles subissent une trempe. Le Zr-$\beta$ sain résiduel se transforme de nouveau en Zr-$\alpha$, dénommé Zr-ex-$\beta$ pour le différencier du Zr-$\alpha$ (O) riche en oxygène formé à haute température. Les phases $ZrO_2$ et Zr-$\alpha$ (O) restent quant à elles inchangées.

A l'issue de la trempe, les couches suivantes se succèdent alors de la surface externe vers la surface interne de la gaine : $ZrO_2$, Zr-$\alpha$ (O), Zr-$\alpha$ (O)+ Zr-ex-$\beta$, Zr-ex-$\beta$.

La présence des phases $ZrO_2$, Zr-$\alpha$(O) (voire Zr-ex-$\beta$ si la teneur en oxygène est élevée) fragilisent l'alliage de zirconium constitutif de la gaine. Il en résulte un risque de rupture de confinement de la matière fissile aussi bien à haute température que lors de la trempe ou pendant les opérations de manutention post-trempe. Des difficultés pour refroidir les assemblages de crayons combustibles apparaissent également lors de la perte d'une géométrie permettant le refroidissement en cas de fragmentations multiples de ces crayons.

- structure différente de l'oxyde $ZrO_2$ : de monoclinique à température modérée, l'oxyde $ZrO_2$ passe en phase quadratique aux alentours de 1050 °C à 1100 °C. Ceci provoque des phénomènes d'instabilité dans la couche d'oxyde

ZrO$_2$ conduisant à des mécanismes d'oxydation particuliers (phénomène de « breakaway », notamment au voisinage de 1000 °C). Les contraintes internes qui en résultent sont a priori défavorables à la bonne adhérence entre le substrat à base de zirconium et son revêtement.

Malgré ce contexte propre aux conditions accidentelles, les inventeurs ont pu mettre au point un matériau multicouche qui présente une résistance améliorée à l'oxydation dans de telles conditions. De façon inattendue, ce matériau a en outre pour avantages que son revêtement multicouche présente une bonne adhérence au substrat à base de zirconium, et ce malgré des variations dimensionnelles locales dues à la structure Zr-β, à l'accélération des mécanismes de diffusion et aux phénomènes d'instabilité dans la couche de l'oxyde ZrO$_2$. Il présente également une bonne résistance à l'hydruration.

Comme démontré dans les exemples ci-après, ces propriétés du matériau multicouche de l'invention sont dues à la combinaison d'une structure et d'une composition particulières.

La structure du matériau multicouche est telle que le revêtement résulte de la superposition d'au moins deux couches métalliques afin de former un revêtement multicouche qui permet d'améliorer la résistance à l'oxydation, voire à l'hydruration, par rapport à un revêtement monocouche de même composition.

Un matériau multicouche se distingue d'un matériau monocouche de composition chimique globale équivalente, notamment par la présence d'interface entre les couches. Cette interface est telle qu'elle correspond généralement à une perturbation de la microstructure à l'échelle atomique. Elle est par exemple identifiée à l'aide d'une technique de caractérisation fine telle que la Microscopie Electronique en Transmission (MET) à haute résolution, la spectroscopie EXAFS (« Extended X-Ray Absorption Fine Structure »), ....

Un matériau multicouche est généralement obtenu par un procédé permettant de réaliser un dépôt séquencé de différentes monocouches. Ainsi, dans la présente description, on entend définir par « couches métalliques séquentielles » des couches métalliques déposées avec un dépôt séquencé.

Outre le caractère multicouche, la structure du matériau multicouche peut-être telle que :

- le revêtement multicouche comprend de 2 à 2000 couches métalliques, préférentiellement de 2 à 1000, encore plus préférentiellement de 2 à 50 couches métalliques, et/ou ;

couches métalliques permet de limiter l'impact sur le comportement neutronique du coeur d'un réacteur nucléaire.

Sauf indication contraire, il est à noter qu'une épaisseur cumulée ne dépassant pas 10 μm, n'interdit pas de réaliser un matériau multicouche conforme à l'invention dans lequel l'épaisseur totale du revêtement est supérieure à 10 μm, typiquement de 1 μm à 20 μm. Par exemple, en plus des couches métalliques, le revêtement multicouche peut comprendre une ou plusieurs couches supplémentaires, placée(s) entre deux couches du revêtement ou en surface du revêtement, en vue de lui conférer au moins une propriété additionnelle.

L'épaisseur d'une couche métallique, le nombre et l'épaisseur cumulée de ces couches métalliques étant des paramètres interdépendants, seuls deux de ces paramètres peuvent être définis afin de déterminer le troisième. Ainsi, par exemple, lorsque l'épaisseur cumulée des couches métalliques de 3 nm chacune est 10 μm, ceci implique que le nombre de couches est de 3334.

Préférentiellement, afin d'améliorer encore la résistance à l'oxydation en conditions accidentelles, le revêtement multicouche comprend au moins dix couches métalliques dont chacune présente une épaisseur d'au moins 100 nm, l'épaisseur cumulée des couches métalliques étant de 1 μm à 6 μm.

Concernant sa composition, le matériau multicouche de l'invention est tel que les couches métalliques constituant tout ou partie du revêtement multicouche sont composées de matières identiques ou différentes choisies parmi le chrome, un alliage de chrome ou un alliage ternaire du système Nb-Cr-Ti. Le revêtement multicouche pouvant être composé de couches de compositions identiques ou différentes, plusieurs modes de réalisation sont possibles.

Selon un premier mode de réalisation du matériau multicouche de l'invention, le revêtement multicouche est composite : les couches métalliques sont de compositions différentes. Il s'agit par exemple d'un revêtement multicouche noté « Cr/Nb-Cr-Ti », dont les couches métalliques sont composées d'une matière à base de chrome (chrome et/ou alliage de chrome), et d'un alliage ternaire du système Nb-Cr-Ti. Ainsi, les couches métalliques sont i) une ou plusieurs couches composées de chrome et/ou d'un alliage de chrome et ii) une ou plusieurs couches composées de l'alliage ternaire du système Nb-Cr-Ti.

Les couches de compositions différentes peuvent être présentes dans le revêtement multicouche composite selon une proportion variable, et disposées en alternance ou selon un ordre aléatoire. Toutefois, une couche métallique composée de chrome ou d'alliage de chrome, dite couche intermédiaire d'accrochage, est généralement celle en contact avec le substrat à base de zirconium avec lequel elle présente une bonne adhérence et compatibilité.

Selon un deuxième mode de réalisation, le revêtement multicouche est majoritaire en chrome : les couches métalliques sont toutes composées de chrome et/ou d'un alliage de chrome, et forment un revêtement multicouche noté « Cr/Cr ». Un matériau multicouche pourvu d'un tel revêtement s'est avéré particulièrement résistant à l'oxydation en conditions accidentelles.

Selon un troisième mode de réalisation, le revêtement multicouche est minoritaire en chrome : les couches métalliques sont toutes composées d'un alliage ternaire du système Nb-Cr-Ti et forment un revêtement multicouche noté « Nb-Cr-Ti/Nb-Cr-Ti ».

De préférence, pour ces modes de réalisation :

- l'alliage de chrome est composé de 80 % à 99 % en atome de chrome, et/ou ;
- les couches métalliques composées de chrome ou d'un alliage de chrome contiennent au moins un élément chimique choisi parmi le silicium ou l'yttrium, un tel élément présent par exemple à une teneur de 0,1 % à 20 % en atome pouvant conférer une amélioration supplémentaire de la résistance à la corrosion, et/ou ;
- la ou les couches métalliques composées d'un alliage ternaire du système Nb-Cr-Ti apportent une ductilité supplémentaire. Elles présentent alors généralement une épaisseur faible, qui est de préférence de 5 nm à 500 nm, afin de limiter les problèmes de capture neutronique ou d'activation sous flux.

L'alliage ternaire du système Nb-Cr-Ti est l'appellation consacrée par l'homme du métier pour désigner ce type d'alliage, sans que cela ne corresponde à une nomenclature ou à une stoechiométrie définie. Cet alliage ternaire du système Nb-Cr-Ti est décrit par exemple dans la publication « D.L. DAVIDSON, K.S. CHAN, and D.L. ANTON, The Effects on Fracture Toughness of Ductile-Phase composition and Morphology in Nb-Cr-Ti and Nb-Si In Situ Composites, METALLURGICAL AND MATERIALS TRANSACTIONS A, 27A (1996) 3007-3018 ». Il peut par exemple comprendre en atome de 50 % à 75 % de niobium, de 5 % à 15 % de chrome et de 20 % à 35 % de titane, ce qui équivaut à un alliage ternaire comprenant en poids de 65 % à 85 % de niobium, de 3 % à 11 % de chrome et de 12 % à 24 % de titane.

Concernant la composition du substrat, il est à base de zirconium, à savoir qu'il contient entre 50 % et 100 % d'atome de zirconium. Le substrat est donc en zirconium ou en un alliage de zirconium. L'alliage de zirconium peut-être choisi parmi le Zircaloy-2, le Zircaloy-4, le Zirlo™ ou le M5™. Ces alliages de zirconium sont bien connus de l'homme du métier dans le domaine nucléaire. Les compositions de ces alliages sont telles qu'ils comprennent par exemple en poids :

- alliage Zircaloy-2 : 1,20 % à 1,70 % de Sn ; 0,07 % à 0,20 % de Fe ; 0,05 % à 1,15 % de Cr ; 0,03 % à 0,08 % de Ni ; 900 ppm à 1500 ppm d'O ; le reste de zirconium
- alliage Zircaloy-4 : 1,20 % à 1,70 % de Sn ; 0,18 % à 0,24 % de Fe ; 0,07 % à 1,13 % de Cr ; 900 ppm à 1500 ppm d'O ; moins de 0,007 % de Ni ; le reste de zirconium
- alliage Zirlo : 0,5 % à 2,0 % de Nb ; 0,7 % à 1,5 % de Sn ; 0,07 % à 0,28 % d'au moins un élément choisi parmi Fe, Ni, Cr ; jusqu'à 200 ppm de C ; le reste de zirconium
- alliage M5 : 0,8 % à 1,2 % de niobium ; 0,090 % à 0,149 % d'oxygène ; le reste de zirconium.

Le substrat constitue généralement un élément massif. Cet élément massif peut être vierge de tout revêtement, et constitue par exemple une pièce constitutive d'un réacteur nucléaire, telle qu'une gaine de combustible nucléaire, un tube guide, une grille d'espacement ou un combustible à plaque.

Ne faisant pas partie de l'invention, on décrit également un revêtement multicouche en tant que tel comprenant des couches métalliques dont la totalité ou une partie est composée d'un alliage ternaire du système Nb-Cr-Ti.

Lorsque toutes les couches métalliques sont composées d'un alliage ternaire du système Nb-Cr-Ti, il s'agit du revêtement multicouche minoritaire en chrome noté « Nb-Cr-Ti/Nb-Cr-Ti ».

Lorsqu'une partie des couches métalliques est composée de l'alliage ternaire du système Nb-Cr-Ti, le revêtement multicouche composite est par exemple tel que les couches métalliques sont i) une ou plusieurs couches composées de chrome et/ou d'un alliage de chrome et ii) une ou plusieurs couches composées de l'alliage ternaire du système Nb-Cr-Ti (revêtement multicouche noté « Cr/Nb-Cr-Ti »).

Le revêtement multicouche décrit mais ne faisant pas partie de l'invention comprend au moins deux couches, et le cas échéant en outre une couche externe d'accrochage. Cette couche d'accrochage est positionnée sur une face du revêtement multicouche, afin de faciliter ultérieurement la liaison avec un substrat. Elle est de préférence composée de chrome ou d'un alliage de chrome, notamment lorsque le substrat est composé de zirconium ou d'alliage de zirconium. Cette couche externe d'accrochage constituera la couche intermédiaire d'accrochage lorsque le substrat sera pourvu du revêtement multicouche.

Le revêtement multicouche décrit mais ne faisant pas partie de l'invention peut se présenter selon une ou plusieurs des variantes décrites précédemment pour le matériau multicouche, notamment les variantes relatives à sa structure et/ou à sa composition.

Le cas échéant, le revêtement multicouche décrit mais ne faisant pas partie de l'invention peut être déposé sur un substrat à l'aide d'un procédé tel qu'un assemblage par diffusion, réalisé par précédemment pour le matériau multicouche, notamment les variantes relatives à sa structure et/ou à sa composition.

Le cas échéant, le revêtement multicouche de l'invention peut être déposé sur un substrat à l'aide d'un procédé tel qu'un assemblage par diffusion, réalisé par exemple en chauffant le revêtement multicouche à une température de 500 °C à 600 °C.

L'invention concerne également une pièce composée en tout ou partie du matériau multicouche ou du revêtement multicouche de l'invention tels que définis précédemment, la pièce étant constitutive d'un réacteur nucléaire, par exemple de type réacteur à Eau sous Pression (« REP »), à Eau Bouillante (« REB ») ou de type réacteurs de quatrième génération.

La pièce est par exemple une pièce tubulaire telle qu'une gaine de combustible nucléaire ou un tube guide, une grille d'espacement ou un combustible à plaque (destiné par exemple à un Réacteur à Neutrons Rapides de type RNR-G).

Préférentiellement, le matériau multicouche, ou le revêtement ne faisant pas partie de l'invention, recouvre la surface externe de la pièce.

Ne faisant pas partie de l'invention, on décrit également l'utilisation d'un matériau multicouche, d'un revêtement multicouche ou d'une pièce selon l'une quelconque des revendications précédentes, afin d'améliorer la résistance à l'oxydation en conditions accidentelles en milieu nucléaire d'un substrat à base de zirconium.

L'invention concerne également un procédé de fabrication d'un matériau multicouche tel que défini précédemment, notamment dans une ou plusieurs des variantes de ce matériau, comprenant une étape dans laquelle on recouvre un substrat à base de zirconium avec un revêtement multicouche comprenant de 2 à 50 couches métalliques qui présentent chacune une épaisseur de 3 nm à 1 um et telles que :

- lesdites couches métalliques sont composées de matières identiques et déposées avec un dépôt séquencé choisi parmi une opération de dépôt physique en phase vapeur (PVD), de dépôt chimique en phase vapeur (CVD) ou d'électrodéposition au cours duquel lesdites couches métalliques sont déposées les unes après les autres, ou
- lesdites couches métalliques sont composées de matières différentes,

les matières identiques ou différentes étant choisies parmi le chrome, un alliage de chrome ou un alliage ternaire du système Nb-Cr-Ti.

Préférentiellement, on recouvre le substrat avec un revêtement multicouche en effectuant un dépôt séquencé des couches métalliques, c'est-à-dire un dépôt dans lequel les couches métalliques sont déposées les unes après les autres. Pour cela, le dépôt séquencé comprend au moins un temps de pause séparant le dépôt de chacune des couches métalliques et durant lequel le dépôt cesse.

Une grande variété de techniques de dépôt séquencé peut être envisagée.

Par exemple, on peut choisir une technique de dépôt séquencé de telle sorte que le revêtement multicouche fabriqué soit suffisamment dense pour recouvrir, sans défauts majeurs d'étanchéité, le substrat ou la couche métallique inférieure sur laquelle on effectue le dépôt, la structure et les propriétés usuelles de ces derniers n'étant pas notablement affectées. A cet effet, on peut recouvrir le substrat en effectuant un dépôt séquencé à l'aide d'une opération de dépôt physique en phase vapeur (« Physical à 700 °C. De préférence, le dépôt physique en phase vapeur est réalisé à une température de 200 °C à 600 °C, préférentiellement de 200 °C à 450 °C.

Préférentiellement, le dépôt physique en phase vapeur est une pulvérisation cathodique (ou « sputtering »).

La pulvérisation cathodique consiste à réaliser des couches minces par éjection d'atomes d'un matériau cible lors d'un bombardement par des ions de gaz rare accélérés sous haute tension. Les atomes éjectés forment ensuite une vapeur métallique qui se condense à la surface d'un substrat pour former un revêtement.

La pulvérisation cathodique peut être mise en oeuvre à l'aide d'une cathode plane et d'une cible plane, ou d'une cathode cylindrique et d'une cible creuse contenant le substrat.

Préférentiellement, la pulvérisation cathodique est de type magnétron. Un magnétron est un jeu d'aimants permanents situé sous la cible afin d'augmenter la densité ionique au voisinage de celle-ci. L'effet magnétron permet d'entretenir la décharge avec une plus faible pression, améliorant d'autant la qualité de la pulvérisation.

La pulvérisation cathodique magnétron est dès lors un procédé rapide, reproductible et permettant de réaliser un revêtement dense. Elle est connue de l'homme du métier, et décrite par exemple dans le document « Techniques de l'ingénieur, pulvérisation cathodique magnétron, Référence M1654 ».

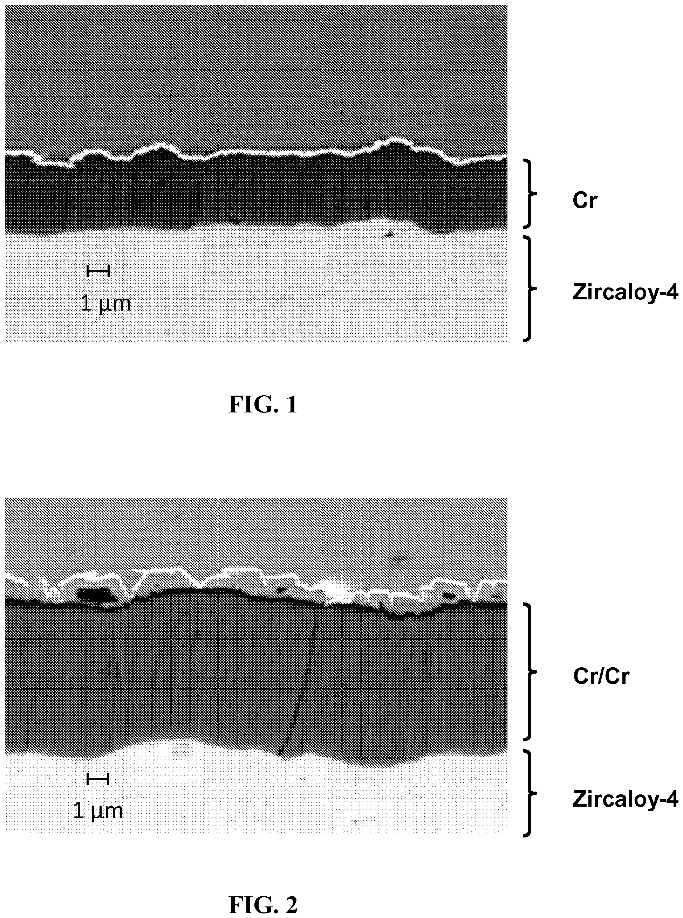

D'autres objets, caractéristiques et avantages de l'invention vont maintenant être précisés dans la description qui suit de modes de réalisation particuliers du procédé de l'invention, donnés à titre illustratif et non limitatif, en référence aux Figures 1 à 22 annexées.

## BREVE DESCRIPTION DES FIGURES

Les Figures 1 à 4 représentent des clichés de Microscopie Electronique à Balayage (MEB) de matériaux constitués d'un substrat de Zircaloy-4 pourvu d'un revêtement monocouche Cr (Figure 1), multicouche Cr/Cr (Figure 2), monocouche Nb-Cr-Ti (Figure 3) et multicouche Cr/Nb-Cr-Ti (Figure 4).

La Figure 5 est un graphe indiquant la prise de masse en conditions nominales, en fonction du temps, de matériaux constitués d'un substrat en Zircaloy-4 pourvu ou non d'un revêtement monocouche ou multicouche.

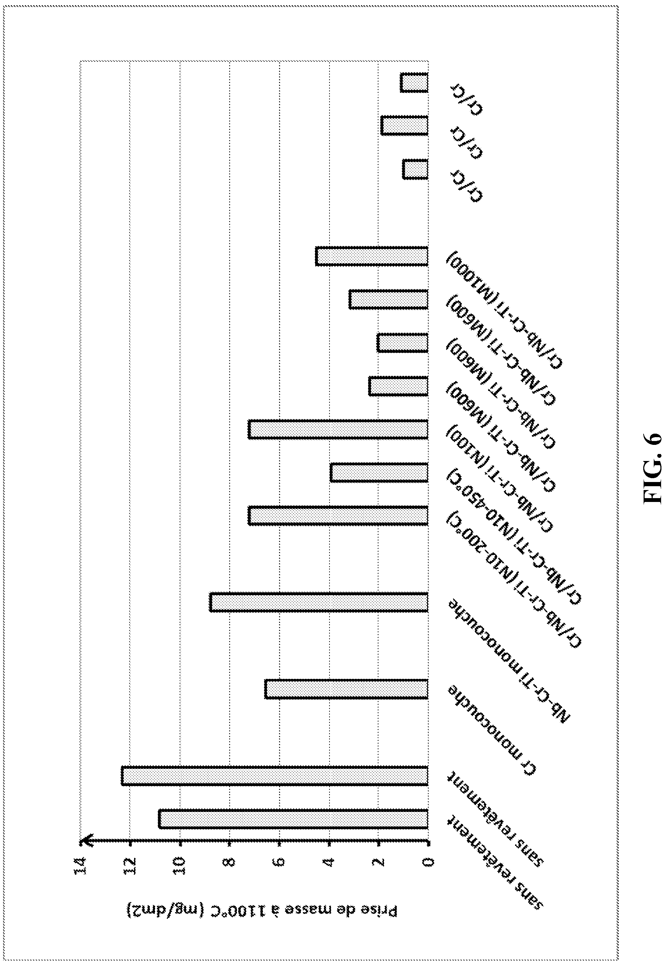

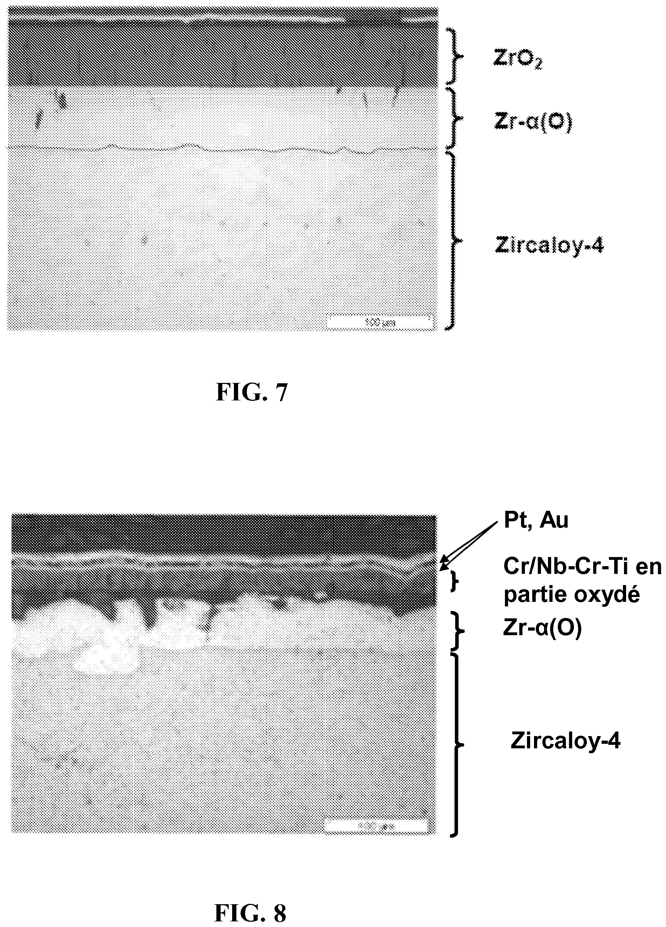

Le diagramme de la Figure 6 illustre la prise de masse en conditions accidentelles, après 850 secondes, de matériaux constitués d'un substrat en Zircaloy-4 pourvu ou non d'un revêtement monocouche ou multicouche. Les clichés en microscopie optique sur section polie des Figures 7 à 12 illustrent cette prise de masse, pour des matériaux constitués d'un substrat en Zircaloy-4 :

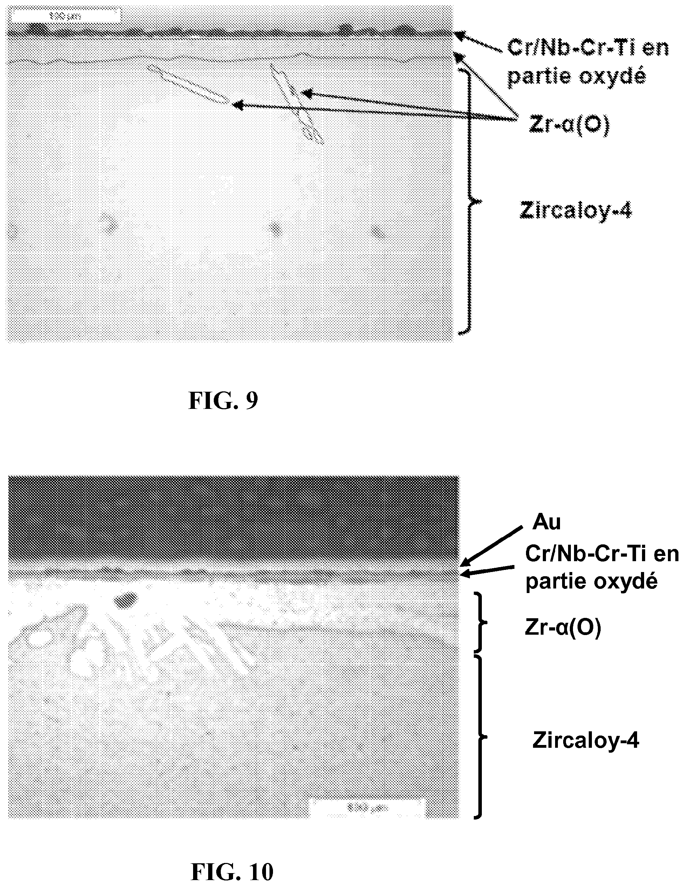

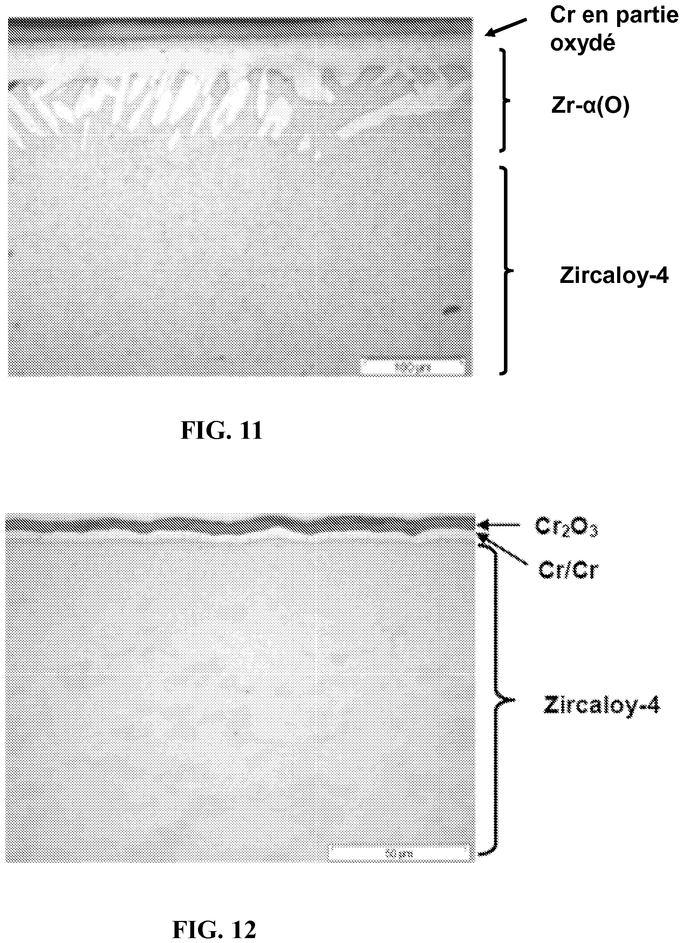

- sans revêtement (Figure 7),
- avec un revêtement monocouche Nb-Cr-Ti (Figure 8),
- avec un revêtement multicouche Cr/Nb-Cr-Ti de référence M600 (Figure 9) ou de référence M1000 (Figure 10),
- avec un revêtement monocouche Cr (Figure 11),
- avec un revêtement multicouche Cr/Cr (Figure 12).

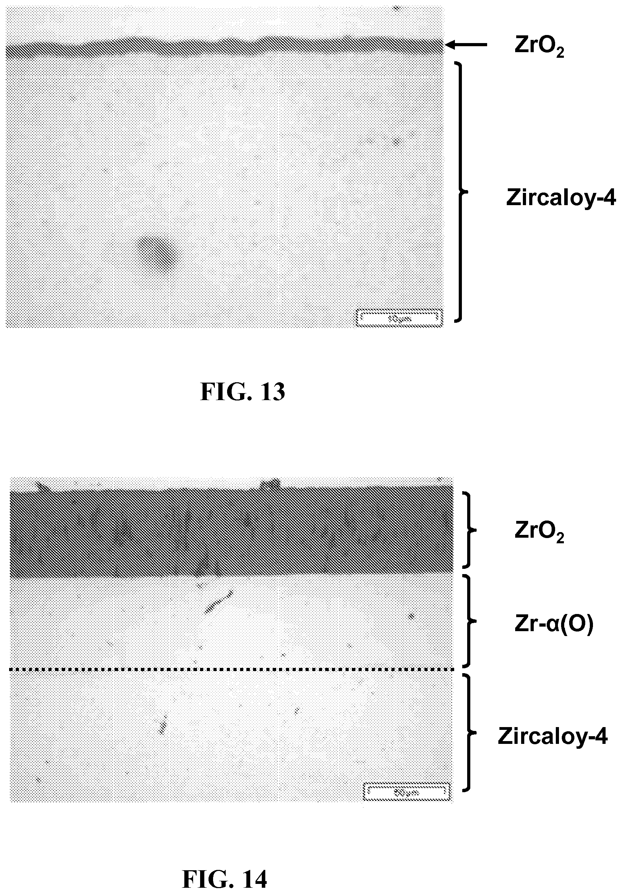

Les Figures 13 à 18 sont des micrographies obtenues par microscopie optique sur section polie de matériaux constitués d'un substrat en Zircaloy-4 :

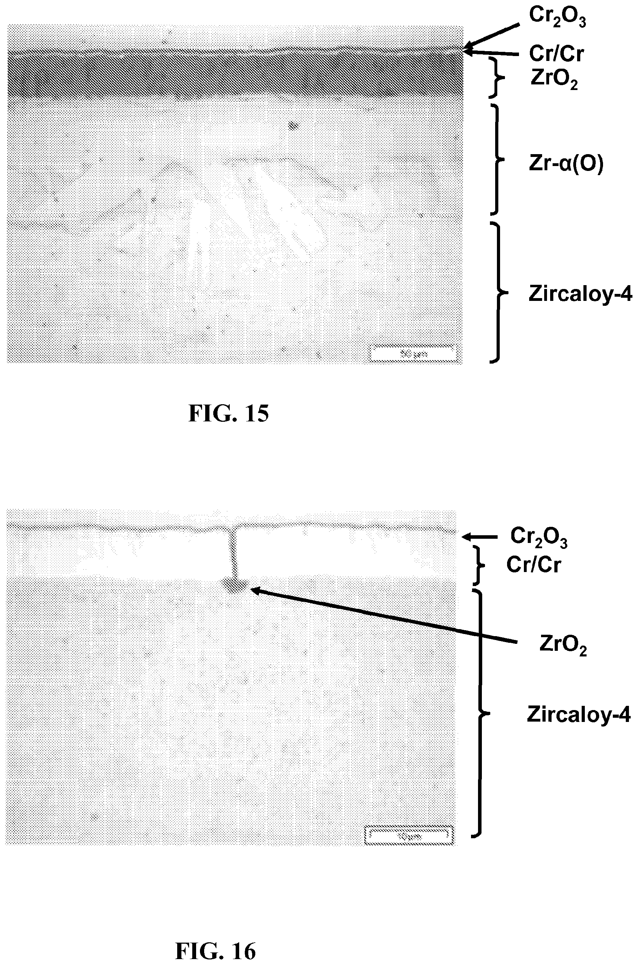

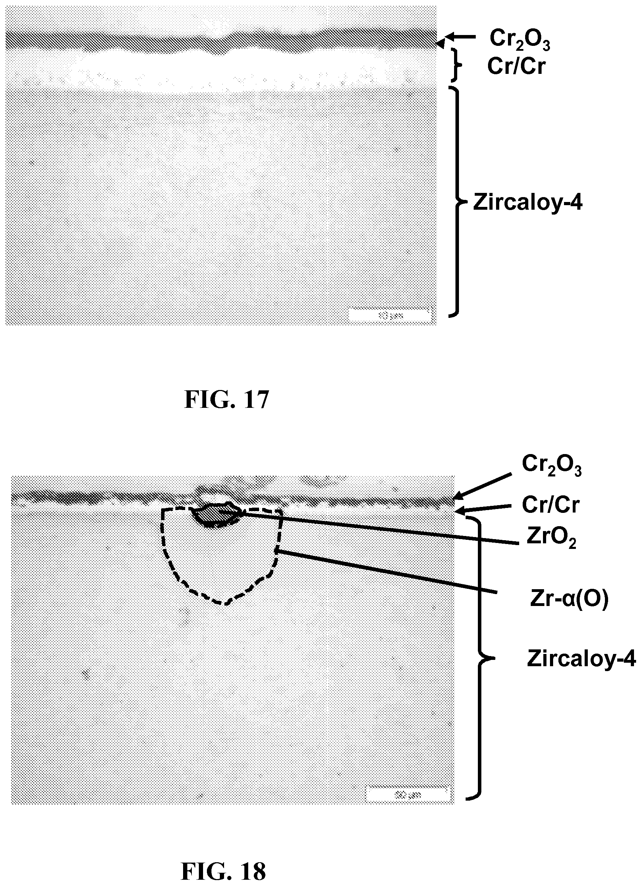

- sans revêtement, après avoir subi une oxydation en conditions nominales (Figure 13) puis une oxydation en conditions accidentelles (Figure 14),
- avec revêtement monocouche Cr, après avoir subi une oxydation en conditions nominales puis accidentelles (Figure 15),
- avec revêtement multicouche Cr/Cr, après avoir subi une oxydation en conditions nominales (Figure 16) puis une oxydation en conditions accidentelles (Figure 17). La Figure 18 est une micrographie du matériau de la Figure 17 d'une zone non représentée sur cette figure et dans laquelle le revêtement comporte une fissure.

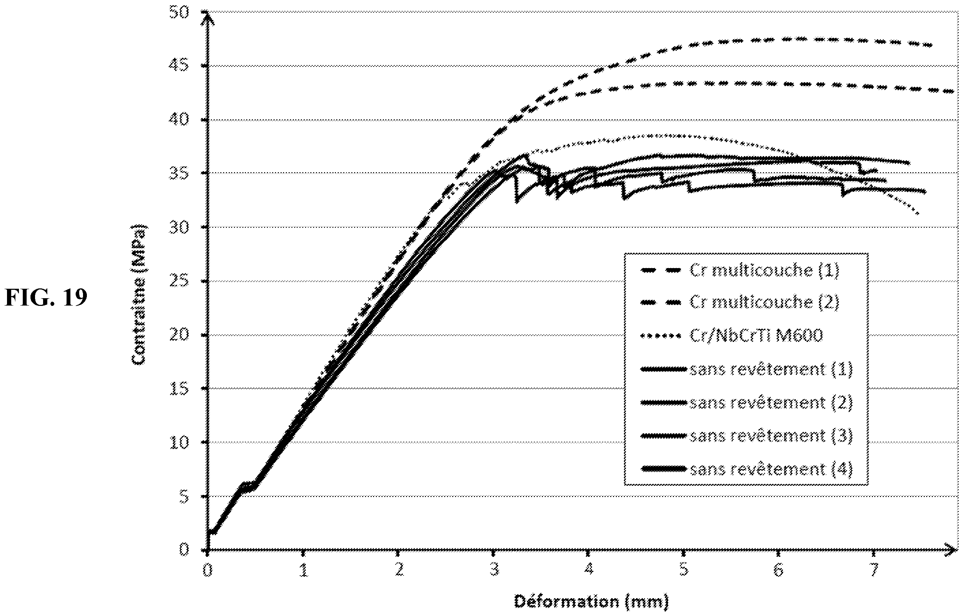

La Figure 19 représente la déformation en flexion à température ambiante en fonction d'une contrainte appliquée sur des éprouvettes en Zircaloy-4 sans revêtement et avec revêtements multicouches Cr/Nb-Cr-Ti et Cr/Cr.

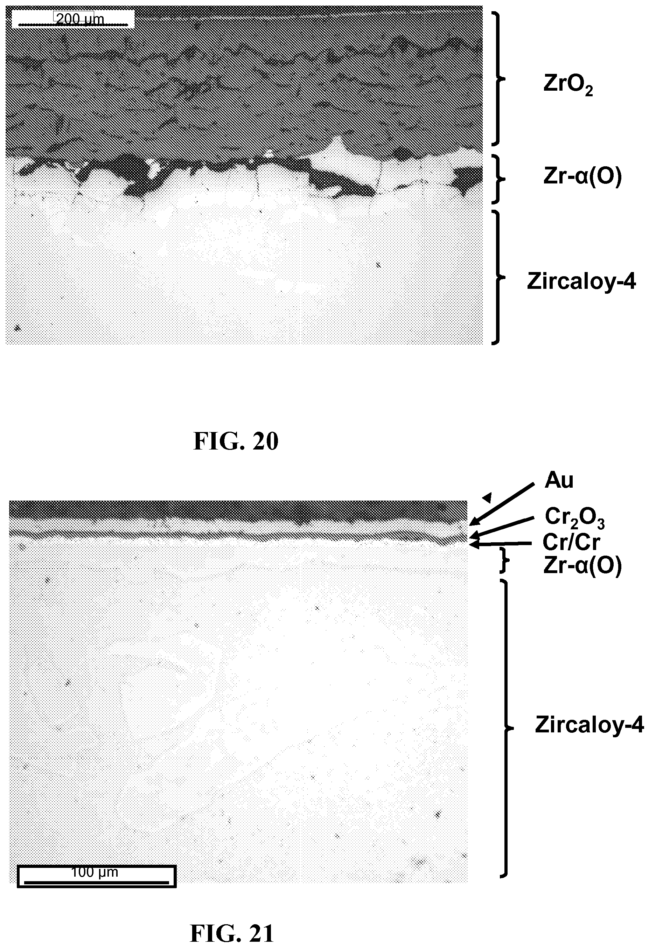

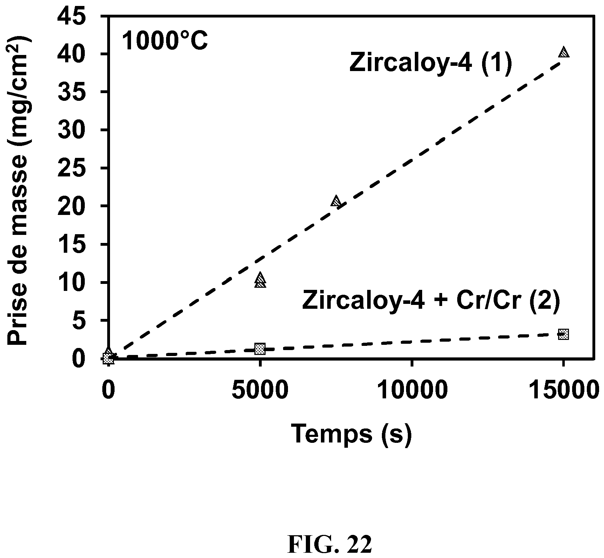

Les figures 20 et 21 sont des clichés MEB qui illustrent l'oxydation après 15000 secondes sous vapeur d'eau à 1000 °C, pour des matériaux constitués d'un substrat en Zircaloy-4 sans revêtement (Figure 20) et pourvu d'un revêtement multicouche Cr/Cr (Figure 21). Les effets de cette oxydation sont illustrés par le graphe de la Figure 22 qui montre l'évolution de la prise de masse au cours du temps pour les matériaux constitués d'un substrat en Zircaloy-4 sans revêtement (droite 1) et pourvu d'un revêtement multicouche Cr/Cr (droite 2).

## EXPOSE DE MODE DE REALISATIONS PARTICULIERS

Dans les exemples qui suivent, on réalise divers matériaux en déposant sur un substrat en Zircaloy-4 :

i) des revêtements monocouches témoins composés de chrome ou d'un alliage ternaire du système Nb-Cr-Ti, et
ii) des revêtements multicouches selon l'invention alternant des couches de chrome (Cr/Cr), ou des couches de chrome et des couches de l'alliage ternaire du système Nb-Cr-Ti (Cr/Nb-Cr-Ti).

Tous les revêtements présentent des épaisseurs similaires.

L'alliage ternaire du système Nb-Cr-Ti choisi est l'alliage $Nb_{67\%}Cr_{10\%}Ti_{23\%}$, dont la formule est exprimée en pourcentage atomique.

La résistance à l'oxydation et à l'hydruration, les caractéristiques structurales et les propriétés mécaniques des matériaux sont testées en conditions nominales (360 °C, eau à 190 bars) et en conditions représentatives d'un accident de type APRP (1100 °C, eau vapeur) avec ou sans oxydation préalable en conditions nominales, selon les conditions représentatives de celles rencontrées pour un réacteur nucléaire de type REP.

Les analyses structurales sont en particulier réalisées par microscopie optique sur section polie. À cet effet, les plaquettes des matériaux analysés sont préparées en les recouvrant d'un revêtement de platine (flash) et d'un revêtement d'or (électrolytique) avant enrobage dans une résine en vue du polissage. Ces revêtements platine et or protecteurs évitent l'arrachage pendant le polissage du revêtement monocouche ou multicouche PVD qui est fragilisé par l'oxydation. Ils permettent également d'améliorer la qualité d'image au microscope par conduction électronique. Ces revêtements protecteurs sont indiqués sur les micrographies lorsqu'ils apparaissent suffisamment nettement.

**1. Fabrication de matériaux multicouches selon l'invention et de matériaux réalisés à titre comparatif.**

La technique de pulvérisation cathodique magnétron est mise en oeuvre pour fabriquer les matériaux précités.

Des plaquettes de Zircaloy-4 de dimension 45 mm $\times$ 14 mm $\times$ 1,2 mm sont dégraissées dans une lessive alcaline, rincées à l'eau, nettoyées aux ultra-sons pendant 30 minutes dans un bain d'acétone, puis rincées à l'éthanol et étuvées.

Elles sont ensuite placées dans un réacteur de pulvérisation cathodique, et décapées in situ en opérant avec une pression partielle d'argon de 4 Pa et une tension de polarisation de 600 V.

Sur les deux faces de chaque plaquette de Zircaloy-4, les revêtements monocouches de chrome pur ou de $Nb_{67\%}Cr_{10\%}Ti_{23\%}$, ainsi que les revêtements multicouches correspondants ($Cr/Cr$ ou $Cr/Nb_{67\%}Cr_{10\%}Ti_{23\%}$) sont déposés à 200 °C par pulvérisation cathodique de cibles de chrome et de cibles composites présentant des inserts de niobium, de chrome et de titane en proportions adéquates.

La pression partielle d'argon est de 0,5 Pa, elle est généralement comprise entre 0,05 Pa et 2 Pa.

La tension de polarisation est de - 100 V. Elle est typiquement comprise entre -10 V et -400 V.

Afin de faciliter son adhérence, le revêtement monocouche Nb-Cr-Ti est réalisé sur une couche d'accrochage en chrome de 500 nm recouvrant le Zircaloy-4. L'épaisseur de la couche d'accrochage peut être diminuée afin de limiter son impact sur la composition globale du revêtement, en particulier lorsque le revêtement comporte peu de couches.

Les revêtements multicouches Cr/Cr sont réalisés en interrompant la décharge magnétron plusieurs fois pendant le dépôt, chaque décharge étant séparée par un temps de pause

Les revêtements multicouches Cr/Nb-Cr-Ti sont réalisés par le passage alternatif des échantillons face à chaque cible de Cr puis de Nb-Cr-Ti, avec un temps de décharge face à chaque cible fixé en fonction de la période « $\lambda$ » désirée. La cinématique des précurseurs métalliques dans l'enceinte permet de contrôler précisément l'épaisseur de chaque couche élémentaire formant le revêtement multicouche. Ce contrôle est possible à partir d'une épaisseur de couche de 3 nm.

Les conditions opératoires de la pulvérisation cathodique magnétron et les caractéristiques des revêtements obtenus sont indiqués dans le Tableau 1. Une période correspond à la réalisation d'une couche de chrome pour les revêtements multicouches Cr/Cr, ou au motif résultant de l'addition d'une couche de Cr et d'une couche de Nb-Cr-Ti déposées successivement pour les revêtements multicouches Cr/Nb-Cr-Ti.

Tableau 1

| Nature du revêtement | Nom | Architecture du revêtement | Epaisseur cumulée du revêtement ($\mu$m) | Température (°C) | Puissance (W) |
|---|---|---|---|---|---|
| Cr | Cr | Monocouche | 1 à 5 | 200 | 400 (Cr) |
| Cr | Cr/Cr | Multicouche $\lambda$ = 500 nm 14 périodes | 7 | 200 | 400 (Cr) |
| $Nb_{67\%}Cr_{10\%}Ti_{23\%}$ (at%) | NbCrTi | Monocouche (avec couche d'accroche de Cr de 500 nm) | 4 | 400 | 450 (NbCrTi) |
| Cr et $Nb_{67\%}Cr_{10\%}Ti_{23\%}$ (at%) | Cr/ NbCrTi N10 | Multicouche $\lambda$ = 2 $\times$ 5 nm > 500 périodes | 5 à 6 | 200 450 | 400 (Cr) 450 (NbCrTi) |
| Cr et $Nb_{67\%}Cr_{10\%}Ti_{23\%}$ (at%) | Cr/ NbCrTi N100 | Multicouche $\lambda$ = 2 $\times$ (50 à 80) nm 40 périodes | 5,5 | 200 | 400 (Cr) 450 (NbCrTi) |
| Cr et $Nb_{67\%}Cr_{10\%}Ti_{23\%}$ (at%) | Cr/ NbCrTi M600 | Multicouche $\lambda$ = 2 $\times$ 300 nm 10 périodes | 6 | 200 | 400 (Cr) 450 (NbCrTi) |

(suite)

| Nature du revêtement | Nom | Architecture du revêtement | Epaisseur cumulée du revêtement ($\mu$m) | Température (°C) | Puissance (W) |
|---|---|---|---|---|---|
| Cr et Nb$_{67\%}$Cr$_{10\%}$Ti$_{23\%}$ (at%) | Cr/ NbCrTi M1000 | Multicouche $\lambda = 2 \times 400$ nm 5 périodes | 4 | 200 | 400 (Cr) 450 (NbCrTi) |

La microstructure des revêtements est observée par MEB sur section polie. Elle est représentée sur les Figures 1 à 4, dans lesquelles le substrat en Zircaloy-4, les couches de chrome et de Nb-Cr-Ti apparaissent.

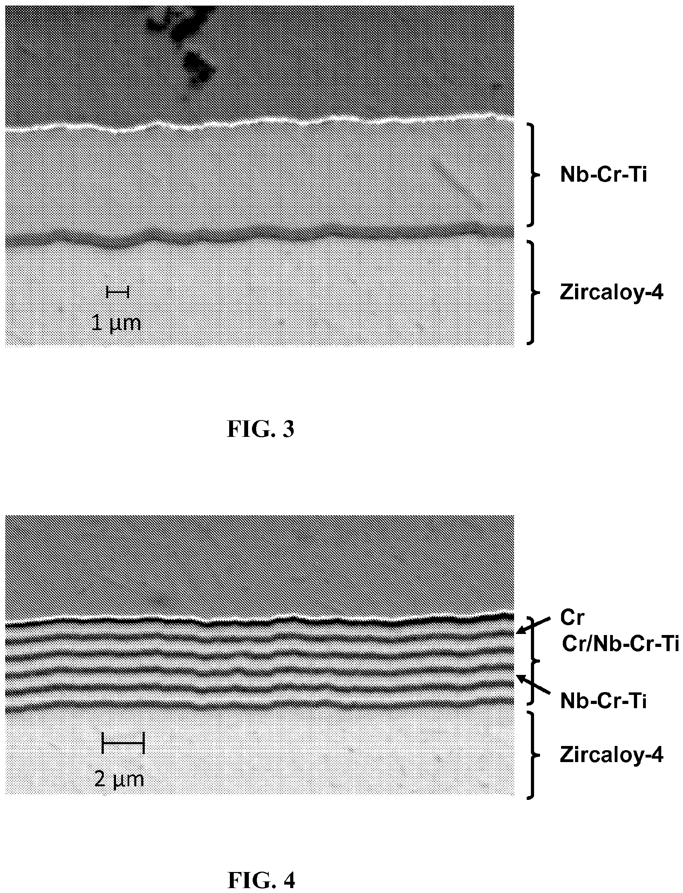

Les interfaces entre les 14 couches du revêtement multicouche Cr/Cr n'apparaissent pas sur le cliché de la Figure 4. Elles peuvent néanmoins être visualisées à l'aide d'une technique haute résolution telle que la Microscopie Electronique en Transmission (MET).

Le revêtement multicouche Cr/Nb-Cr-Ti représenté sur la Figure 4 est celui présentant une période $\lambda = 2 \times$ 300nm (référence M600 du Tableau 1), le chiffre 2 indiquant la présence de deux couches dans une même période. Les couches en gris clair et gris foncé correspondent respectivement aux couches de l'alliage Nb-Cr-Ti et aux couches de chrome.

Ces clichés font apparaître que les revêtements sont denses, d'épaisseur régulière et présentent une bonne adhérence au substrat de Zircaloy-4, sans défaut significatif à l'interface.

## 2. Mesure de la corrosion en conditions nominales (T = 360 °C) et microstructure.

Afin d'évaluer leur résistance à l'oxydation, les plaquettes à base de zirconium pourvues de revêtement réalisées dans l'exemple 1 (à l'exception de la plaquette avec revêtement multicouche Cr/Nb-Cr-Ti de référence M1000) séjournent pendant 60 jours dans un autoclave dont le milieu est représentatif des conditions en fonctionnement nominal d'un réacteur nucléaire de type REP.

À titre comparatif, on ajoute une plaquette témoin de Zircaloy-4 sans revêtement d'épaisseur similaire aux plaquettes avec revêtement.

Le milieu en autoclave est une eau contenant 650 ppm de bore et 10 ppm de lithium, portée à 360 °C et pressurisée à 190 bars.

Des arrêts intermédiaires à 10 jours et 30 jours permettent de mesurer pour les différentes plaquettes la prise de masse traduisant la prise d'oxygène.

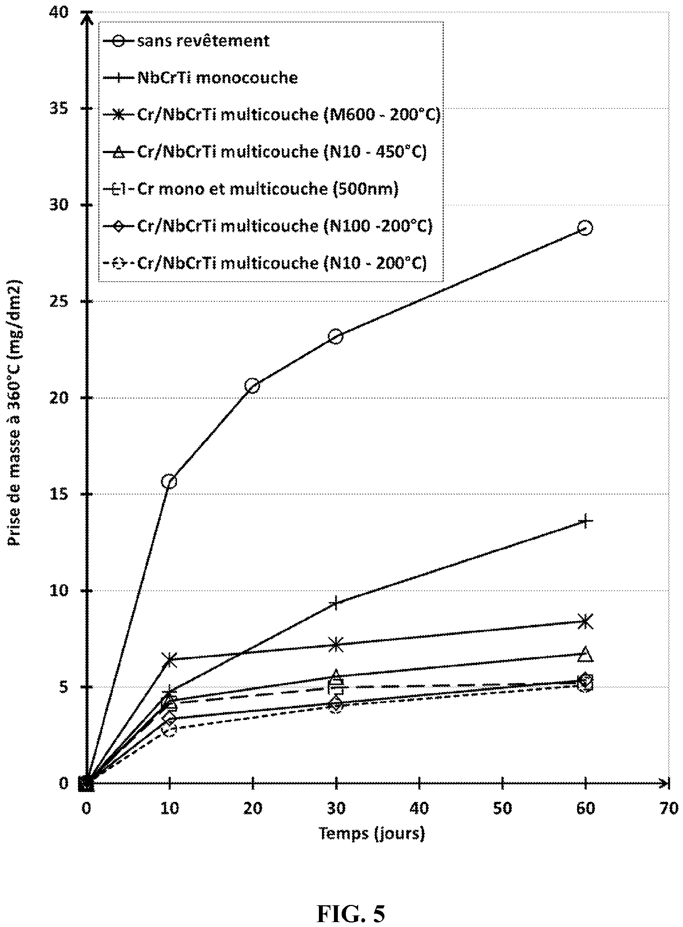

Les résultats des prises de masse jusqu'à 60 jours représentés sur la Figure 5 indiquent que tous les revêtements monocouche et multicouche contenant du chrome conduisent à une amélioration significative de la résistance à l'oxydation en conditions nominales par rapport à la plaquette témoin en Zircaloy-4 sans revêtement.

Par rapport au revêtement monocouche Cr, la résistance à l'oxydation en conditions nominales est similaire pour le revêtement multicouche Cr/Cr, voire supérieure pour deux revêtements multicouches Cr/Nb-Cr-Ti (références N10-200°C et N100-200°C) lorsque l'exposition à l'oxydation est inférieure à 60 jours.

Ces résultats sont confirmés par la mesure de l'épaisseur de la couche d'oxyde sur les plaquettes Zircaloy-4 qui est de 1,8 $\mu$m de zircone (ZrO$_2$) en absence de revêtement, à moins de 0,4 $\mu$m d'oxyde de chrome (Cr$_2$O$_3$) avec les revêtements multicouches qui empêchent la formation d'oxyde de zirconium dans le substrat sous-jacent, à l'exception le cas échéant d'une oxydation au droit de fissures présentes dans le revêtement.

Par ailleurs, des micrographies en microscopie optique sur section polie (non reproduites ici) sont réalisées sur la tranche d'une plaquette en Zircaloy-4 avec revêtement multicouche Cr/Nb-Cr-Ti (référence M600 du Tableau 1). Elles confirment que ce revêtement empêche la formation de ZrO$_2$ constatée pour une plaquette témoin sans revêtement. Cette propriété est obtenue grâce à la formation à la surface du revêtement d'une couche protectrice d'oxyde de chrome (Cr$_2$O$_3$) de 100 nm d'épaisseur, qui constitue une barrière de diffusion à l'oxygène limitant voire en évitant la formation de ZrO$_2$ sous le revêtement multicouche.

Par rapport à un matériau monocouche avec revêtement Cr, il apparaît donc que les matériaux multicouches avec revêtement Cr/Cr ou Cr/Nb-Cr-Ti préservent une bonne résistance à l'oxydation en conditions nominales, voire l'améliore pour un revêtement Cr/Nb-Cr-Ti.

**3. Mesure de la corrosion après 850 secondes en conditions accidentelles sous vapeur d'eau (T = 1100 °C) et microstructure.**

On réalise des tests afin d'évaluer la résistance à l'oxydation en conditions accidentelles des plaquettes à base de zirconium réalisées dans l'exemple 1.

Les conditions sont celles d'un accident de type APRP au cours duquel la température des gaines de combustible nucléaire augmente rapidement jusqu'à plus de 800 °C voire plus de 1050 °C jusqu'à pouvoir atteindre 1200 °C, puis diminue brutalement suite à la trempe par l'eau des douches de sécurité visant à noyer de nouveau le coeur. Les conditions des tests correspondent aux conditions enveloppes d'un accident APRP prises en compte dans les calculs de sureté.

Les plaquettes sont tenues au bout d'une canne en alumine, puis placées pendant 850 secondes dans une enceinte dans laquelle circule de la vapeur d'eau portée à 1100 °C à l'aide d'un four permettant l'oxydation en vapeur d'eau.

On fait ensuite chuter les plaquettes dans un bain de trempe rempli d'eau à température ambiante. Le fond du bain est pourvu d'un coussin amortissant la chute des plaquettes et d'un linge blanc afin de récupérer les particules se désolidarisant des plaquettes dans l'éventualité d'une desquamation des phases fragilisées suite au choc thermique de la trempe.

**3.1. Mesure de la prise de masse.**

Les plaquettes oxydées et les éventuels morceaux desquamés sont pesés afin de déterminer la prise de masse due à la quantité d'oxygène ayant diffusé dans les plaquettes.

La mesure est répétée une fois pour la plaquette de Zircaloy-4 sans revêtement, et deux fois pour les plaquettes avec revêtement multicouche Cr/Nb-Cr-Ti (référence M600) et avec revêtement multicouche Cr/Cr. La différence obtenue dans les valeurs pour une même plaquette est due à la dispersion expérimentale.

Les prises de masse mesurées sont regroupées dans le Tableau 2 et illustrées par le diagramme de la Figure 6.

Tableau 2

| Plaquette | Prise de masse à 1100°C (mg/cm2) |
|---|---|
| | |
| Zircaloy-4 sans revêtement | 10,82 |
| Zircaloy-4 sans revêtement | 12,32 |
| | |
| Zircaloy-4 avec revêtement Cr monocouche | 6,55 |
| | |
| Zircaloy-4 avec revêtement Nb-Cr-Ti monocouche | 8,75 |
| | |
| Zircaloy-4 avec revêtement Cr/Nb-Cr-Ti (N10 - 200°C) | 7,22 |
| Zircaloy-4 avec revêtement Cr/Nb-Cr-Ti (N10 - 450°C) | 3, 92 |
| Zircaloy-4 avec revêtement Cr/Nb-Cr-Ti (N100) | 7,22 |
| Zircaloy-4 avec revêtement Cr/Nb-Cr-Ti (M600) | 2,37 |
| Zircaloy-4 avec revêtement Cr/Nb-Cr-Ti (M600) | 2,04 |
| Zircaloy-4 avec revêtement Cr/Nb-Cr-Ti (M600) | 3,16 |
| Zircaloy-4 avec revêtement Cr/Nb-Cr-Ti (M1000) | 4,5 |
| | |
| Zircaloy-4 avec revêtement Cr/Cr multicouche | 1,01 |
| Zircaloy-4 avec revêtement Cr/Cr multicouche | 1,88 |
| Zircaloy-4 avec revêtement Cr/Cr multicouche | 1,1 |

Ces données suggèrent que les revêtements multicouches Cr/Nb-Cr-Ti et Cr/Cr améliorent la résistance à l'oxydation en conditions accidentelles, non seulement par rapport à l'absence de revêtement, mais également de manière significative par rapport aux revêtements monocouches Cr ou Nb-Cr-Ti correspondants.

Cette résistance est particulièrement améliorée pour les revêtements multicouches contenant au moins 10 couches (et donc d'une épaisseur de couche minimale de 100 nm, de préférence comprise entre 100 nm et 500 nm), plus particulièrement pour les revêtements multicouches Cr/Nb-Cr-Ti de référence M600 (10 périodes) et multicouches Cr/Cr.

Il est néanmoins à noter que, si afin d'évaluer le degré d'oxydation du Zircaloy-4, on peut directement corréler la prise de masse à la prise d'oxygène dans le cas du Zircaloy-4 sans revêtement (formation de $ZrO_2$ et de $Zr$-$\alpha(O)$ en proportion connue), ce n'est a priori pas possible en conditions accidentelles pour des échantillons revêtus car l'oxydation des revêtements contribue également de façon significative à cette prise de masse.

Une telle corrélation est par contre possible en conditions nominales au regard de l'oxydation très limitée des revêtements.

### 3.2. Structure et mesure de l'épaisseur des couches oxydées.

À titre complémentaire, on évalue l'épaisseur des phases $ZrO_2$ et $Zr$-$\alpha(O)$ dans les plaquettes avec revêtement via des examens microstructuraux par microscopie optique sur section polie.

Les micrographies obtenues présentent les microstructures après oxydation en conditions accidentelles des plaquettes sans revêtement (Figure 7), et des plaquettes avec revêtement monocouche Nb-Cr-Ti (Figure 8), multicouches Cr/Nb-Cr-Ti (référence M600 : Figure 9 ; référence M1000 : Figure 10), monocouche Cr (Figure 11) et multicouche Cr/Cr (Figure 12) ayant conduit aux prises de masse les plus faibles à 1100 °C.

Chaque figure fait apparaître une microstructure dans laquelle les couches suivantes se succèdent :

- Figure 7 : couche externe de $ZrO_2$, couche de $Zr$-$\alpha(O)$, substrat de Zircaloy-4 ;
- Figure 8 : couche externe de platine et d'or, revêtement multicouche Cr/Nb-Cr-Ti en partie oxydé, zone sombre correspondant à l'arrachement au polissage dû à la présence de phase fragile, couche de $Zr$-$\alpha(O)$, substrat de Zircaloy-4 ;
- Figure 9 et 10 : revêtement multicouche Cr/Nb-Cr-Ti en partie oxydé (avec couche externe claire constituée d'or dans la Figure 10), couche de $Zr$-$\alpha(O)$ se prolongeant par endroits dans le substrat de Zircaloy-4 sous forme d'aiguilles de $Zr$-$\alpha(O)$ de moins de 100 $\mu$m de longueur projetée dont la présence est délimitée sur la Figure 9 à titre d'exemple, substrat de Zircaloy-4 ;
- Figure 11 : revêtement de chrome en partie oxydé, couche de $Zr$-$\alpha(O)$ se prolongeant par endroits dans le substrat de Zircaloy-4 sous forme d'aiguilles de $Zr$-$\alpha(O)$ de moins de 100 $\mu$m de longueur projetée, substrat de Zircaloy-4 ;
- Figure 12 : couche externe de $Cr_2O_3$ résultant de l'oxydation du revêtement multicouche Cr/Cr, revêtement sain multicouche Cr/Cr, substrat de Zircaloy-4.

Les revêtements multicouches Cr/Nb-Cr-Ti et Cr/Cr (Figures 9, 10 et 12) empêchent donc la formation de l'oxyde fragile $ZrO_2$, alors que cet oxyde recouvre la plaquette sans revêtement sur 60 $\mu$m d'épaisseur (Figure 7).

L'amélioration de la résistance à l'oxydation du Zircaloy-4 en conditions accidentelles grâce à l'usage des revêtements multicouches Cr/Cr ou Cr/Nb-Cr-Ti est également confirmée par la mesure de l'épaisseur des couches de $ZrO_2$, de l'épaisseur équivalente des couches de $Zr$-$\alpha(O)$ et la détermination de l'épaisseur équivalente de Zircaloy-4 oxydé, mesurées sur six plaquettes. Ces mesures sont regroupées dans le Tableau 3. Elles sont corroborées par des analyses complémentaires à la microsonde de Castaing (dosages WDS) des profils de concentration sur la tranche des plaquettes oxydées.

Dans ce tableau, l'épaisseur équivalente de $Zr$-$\alpha(O)$ correspond à l'épaisseur de la couche de $Zr$-$\alpha(O)$ à laquelle est ajoutée l'épaisseur d'une couche dont la surface est équivalente à la surface des aiguilles de $Zr$-$\alpha$ (O).

L'épaisseur équivalente de Zircaloy-4 oxydé (c'est-à-dire de Zircaloy-4 fragilisé par la pénétration d'oxygène) est calculée à partir de la formule suivante :

```
Epaisseur équivalente de Zircaloy-4 oxydé = Epaisseur
équivalente de Zr-α(O) + Epaisseur de ZrO₂/1,56
```

Le coefficient de Pilling-Bedworth qui a pour valeur 1,56 reflète la variation de densité lors de l'oxydation du Zirconium en $ZrO_2$.

Il ressort notamment du Tableau 3, que le revêtement multicouche Cr/Cr présente une bonne étanchéité car, même si une certaine pénétration d'oxygène dans le Zircaloy-4 se produit, cette pénétration n'est pas assez significative pour que du Zr-$\alpha$(O) apparaisse.

Tableau 3

| | Epaisseur des phases ($\mu$m) | | |
|---|---|---|---|
| | ZrO$_2$ | Zr-$\alpha$(O) (épaisseur équivalente) /attaque en aiguilles | Zircaloy-4 oxydé (épaisseur équivalente) |
| Zircaloy-4 sans revêtement | 60 | 62 / NON | 101 |
| Zircaloy-4 avec revêtement monocouche Nb-Cr-Ti | 25 | 80 / NON | 96 |
| Zircaloy-4 avec revêtement multicouche Cr/Nb-Cr-Ti (M600) | 0 | 8 / OUI | 8 |
| Zircaloy-4 avec revêtement multicouche Cr/Nb-Cr-Ti (M1000) | 4,90 | 51 / OUI | 54,70 |
| Zircaloy-4 avec revêtement monocouche Cr | 53 | 57 / OUI | 92 |
| Zircaloy-4 avec revêtement multicouche Cr/Cr | 0 | 0 / NON | 0 |

Même si une observation plus fine de la microstructure montre que les revêtements Cr/Nb-Cr-Ti (M600) et Cr/Cr présentent respectivement sur environ 2 $\mu$m une couche en partie oxydée (respectivement une couche d'oxyde mixte de chrome et de niobium, et une couche d'oxyde de chrome), ces couches oxydées ont un rôle protecteur et sacrificiel vis-à-vis de l'oxydation du Zircaloy-4 sous-jacent.

### 3.3. Mesure de la teneur en oxygène.

Par dosage WDS sur section polie, la teneur en poids en oxygène dans la couche Zr-ex-$\beta$ obtenue après trempe est également mesurée au coeur des plaquettes sur une distance de 400 $\mu$m.
Les mesures regroupées sur le Tableau 4 montrent que la teneur en oxygène de l'alliage de zirconium est significativement abaissée grâce à la présence des revêtements multicouches.

Tableau 4

| | Teneur en oxygène dans la phase ex-$\beta$ (% en poids) |
|---|---|
| Zircaloy-4 sans revêtement | 0,40 $\pm$ 0,07 |
| Zircaloy-4 avec revêtement multicouche Cr/Nb-Cr-Ti | 0,23 $\pm$ 0,03 |
| Zircaloy-4 avec revêtement multicouche Cr/Cr | 0,16 $\pm$ 0,03 |

Ceci est particulièrement avantageux car, lorsque cette teneur en oxygène est supérieure à 0,4 % en poids, la phase ex-$\beta$ a pour inconvénient d'adopter un comportement fragile à 20 °C.
Combinée à une diminution drastique de l'épaisseur des couches de ZrO$_2$ et Zr-$\alpha$(O), les matériaux avec revêtements multicouches Cr/Nb-Cr-Ti et particulièrement Cr/Cr permettent donc d'assurer la ductilité au coeur d'une gaine de combustible nucléaire à base de zirconium. Une telle propriété est déterminante vis-à-vis de la tenue à la trempe et après trempe de la gaine afin de respecter les critères de sûreté liés à l'APRP.

### 3.4. Influence du caractère multicouche.

Les données des tableaux 2, 3 et 4 font clairement apparaître une amélioration très significative de la résistance du substrat en Zircaloy-4 à l'oxydation en conditions accidentelles par l'usage d'un revêtement multicouche au lieu d'un revêtement monocouche de composition équivalente.
Cette amélioration est également illustrée par la comparaison de la microstructure :

-   des substrats en Zircaloy-4 avec revêtement monocouche Nb-Cr-Ti (Figure 8) ou multicouche Cr/Nb-Cr-Ti (référence M600 : Figure 9, et dans une moindre mesure référence M1000 : Figure 10),
-   des substrats en Zircaloy-4 avec revêtement monocouche Cr (Figure 11) ou multicouche Cr/Cr (Figure 12) dont la résistance à l'oxydation du substrat apparaît totale.

## 4. Influence de la composition en conditions nominales et accidentelles.

Afin de déterminer l'influence de la composition du revêtement multicouche de l'invention, on réalise une plaquette constituée d'un substrat en Zircaloy-4 pourvue d'un revêtement multicouche TiN/AlTiN à base de nitrure de titane et de nitrure mixte d'aluminium et de titane. Le revêtement multicouches TiN/AlTiN d'une épaisseur totale de 3,4 $\mu$m est constitué d'une sous-couche de TiN de 200 nm d'épaisseur, à laquelle se superposent plus de 400 couches alternées de AlTiN ou TiN d'environ 7 nm d'épaisseur dont l'épaisseur cumulée est de 3 $\mu$m, puis une couche finale de AlTiN de 200 nm d'épaisseur.

Ce revêtement multicouche est testé en conditions nominales et accidentelles selon les protocoles des exemples 2 et 3. Même si la résistance à l'oxydation du substrat en alliage de zirconium est améliorée par le revêtement TiN/AlTiN en conditions nominales, aucune amélioration n'est par contre constatée en conditions accidentelles.

La prise de masse d'environ 10 mg/cm$^2$ après 800 secondes et 18 mg/cm$^2$ après 3000 secondes, ainsi que l'épaisseur des oxydes formés, sont en effet comparables à la plaquette en Zircaloy-4 sans revêtement.

Les différentes mesures de l'exemple 3 montrent que c'est bien la combinaison de la structure et de la composition du matériau multicouche de l'invention qui permet d'améliorer la résistance à l'oxydation en conditions accidentelles.

## 5. Mesure de la corrosion en conditions accidentelles sous vapeur d'eau (T = 1100 °C) après oxydation préalable en conditions nominales (T = 360 °C) et microstructure.

Un scénario hypothétique accidentel de type APRP peut intervenir à n'importe quel stade de la vie de la gaine de combustible nucléaire en service, donc après une certaine oxydation à basse température.

Les mesures qui suivent sont destinées à évaluer l'impact d'une oxydation préalable en conditions nominales sur l'efficacité des revêtements multicouches Cr/Nb-Cr-Ti, monocouche Cr et multicouche Cr/Cr vis-à-vis de la protection contre l'oxydation en conditions accidentelles.

A cet effet, les plaquettes suivantes sont soumises au protocole d'oxydation et de mesure, successivement, selon l'exemple 2 (conditions nominales) puis selon l'exemple 3 (conditions accidentelles) :

-   une plaquette en Zircaloy-4 sans revêtement ;
-   une plaquette en Zircaloy-4 avec revêtement monocouche Cr ;
-   une plaquette en Zircaloy-4 avec revêtement multicouche Cr/Cr ;
-   une plaquette en Zircaloy-4 avec revêtement multicouches Cr/Nb-Cr-Ti (Référence M600).

### 5.1. Structure et mesure de l'épaisseur des couches oxydées.

Les micrographies obtenues par microscopie optique sur section polie sont reproduites sur les Figures 13 à 18. Elles montrent que la présence d'une couche de pré-oxyde (ZrO$_2$ ou Cr$_2$O$_3$) formée en conditions nominales à la surface des plaquettes n'a que peu d'influence sur l'oxydation ultérieure en conditions accidentelles.

Comme précédemment, une couche de ZrO$_2$ se forme en conditions nominales à la surface de la plaquette en Zircaloy-4 sans revêtement (Figure 13). Cette couche d'oxyde s'épaissit ensuite notablement en conditions accidentelles et s'accompagne de la formation d'une couche sous-jacente de Zr-$\alpha$(O) d'une épaisseur de 62 $\mu$m (Figure 14). Ce comportement est similaire à celui d'une oxydation en conditions accidentelles seule.

Pour la plaquette en Zircaloy-4 avec revêtement monocouche Cr, une couche de Cr$_2$O$_3$ se forme en surface en conditions nominales (non présenté). En conditions accidentelles (Figure 15), la couche de Cr$_2$O$_3$ s'épaissit (couche gris foncé de 1,5 $\mu$m), la couche de Cr non oxydé demeure (couche blanche de 2 pm) mais n'est plus protectrice ce qui conduit à l'oxydation du substrat sous la forme d'une couche de ZrO$_2$ d'une vingtaine de microns et de Zr-$\alpha$(o) sous-jacent d'une soixantaine de microns.

Concernant la plaquette en Zircaloy-4 avec revêtement multicouche Cr/Cr, une couche de Cr$_2$O$_3$ se forme en surface en conditions nominales (Figure 16). Au droit d'une fissure dans le revêtement (défaut rare), des îlots de ZrO$_2$ peuvent se former, d'épaisseur comparable au matériau sans revêtement. En conditions accidentelles, la couche de Cr$_2$O$_3$ s'épaissit ensuite tout en continuant avantageusement à jouer un rôle sacrificiel protecteur, puisque le revêtement multicouche Cr/Cr sous-jacent préserve une épaisseur significative (Figure 17) et empêche l'oxydation de la couche interne de Zircaloy-4. Il est à noter que le comportement du revêtement multicouche Cr/Nb-Cr-Ti (micrographie non reproduite) est similaire à celui du revêtement multicouche Cr/Cr.

Les seuls signes d'oxydation sont ceux positionnés au droit des quelques rares fissures présentes dans le revêtement multicouche Cr/Cr initial : un îlot de ZrO$_2$ formé en conditions nominales et repéré sur la Figure 16 donne naissance en conditions accidentelles à des ilots de ZrO$_2$ et de Zr-$\alpha$(O) qui sont délimités en pointillés sur la Figure 18. Cela démontre le rôle majeur que joue le revêtement multicouche dans la résistance à l'oxydation du Zircaloy-4.

Le Tableau 5 indique pour les différentes plaquettes les épaisseurs équivalentes de Zircaloy-4 oxydé en conditions accidentelles sans (exemple 3) ou avec oxydation préalable en conditions nominales (exemple 4).

Les observations microstructurales et le Tableau 5 confirment que l'oxydation préalable en conditions nominales n'affecte pas l'efficacité ultérieure des revêtements multicouches Cr/Nb-Cr-Ti et Cr/Cr vis-à-vis de la protection contre l'oxydation du substrat en Zircaloy-4 en conditions accidentelles.

Tableau 5

| | Epaisseur équivalente de Zircaloy-4 oxydé ($\mu$m) | |
|---|---|---|
| | Oxydation 850 s à 1100 °C | Oxydation 60 jours à 360 °C + 850 s à 1100 °C |
| Zircaloy-4 sans revêtement | 101 | 99 |
| Zircaloy-4 avec revêtement multicouche Cr/Cr | 0,2 | 8 |

L'oxydation constatée pour le matériau multicouche avec revêtement Cr/Cr est en particulier due à la présence d'une fissure dans le revêtement qui permet la diffusion d'oxygène et l'oxydation du Zircaloy-4 au droit de cette fissure, comme cela est illustré dans les Figures 16 et 18.

### 5.2. Influence du caractère multicouche.

Les données du tableau 5, ainsi que la comparaison de la microstructure du substrat en Zircaloy-4 avec revêtement monocouche Cr (Figure 15) ou avec revêtement multicouche Cr/Cr (Figure 17), confirment que le revêtement multicouche permet d'améliorer la résistance du substrat à l'oxydation en conditions nominales puis accidentelles, par rapport au revêtement monocouche de composition équivalente.

### 6. Propriétés mécaniques après oxydation à 1100 °C.

La ductilité résiduelle d'une gaine de combustible nucléaire soumise à des conditions accidentelles, voire au cours et après la trempe qui suit l'accident, est essentiellement assurée par l'épaisseur de la couche résiduelle de Zr-ex-$\beta$, à condition que la teneur en oxygène de cette couche reste inférieure à la teneur limite de 0,4 % en poids à 20 °C.

Afin d'évaluer leur ductilité résiduelle, des éprouvettes de dimension 25 mm à 45 mm $\times$ 3 mm $\times$ 1 mm en Zircaloy-4 sans revêtement et avec revêtements multicouches Cr/Nb-Cr-Ti (référence M600) et Cr/Cr sont prélevées dans les plaquettes ayant subi une oxydation en conditions accidentelles selon l'exemple 3. Leur résistance mécanique est ensuite testée en flexion trois points à température ambiante.

Les courbes contraintes/déformation obtenues sont reproduites sur la Figure 19.

Elles montrent que l'éprouvette en Zircaloy-4 sans revêtement présente, au-delà du domaine élastique, une certaine déformation. Des instabilités provoquées par les fissurations successives de ZrO$_2$ et Zr-$\alpha$(O) conduisent progressivement à la ruine du matériau, mais permettent d'accommoder la déformation du Zircaloy-4 ductile résiduel sous-jacent et d'éviter la rupture totale de l'éprouvette.

Les éprouvettes en Zircaloy-4 avec revêtements multicouches présentent quant à elles une déformation sans rupture au moins aussi importante, tout en évitant les phénomènes d'écaillage de phase fragile en surface. L'éprouvette en Zircaloy-4 avec revêtement multicouche Cr/Cr possède en particulier une résistance mécanique notablement améliorée, puisqu'elle présente une flèche de 5 mm à 6 mm pour une contrainte pouvant atteindre 42 MPa à 47 MPa.

Cette amélioration de la résistance mécanique peut s'avérer déterminante pour la bonne tenue mécanique d'une gaine de combustible nucléaire avant et après trempe.

**7. Mesure de la corrosion et de la prise d'hydrogène en conditions accidentelles après 15 000 secondes sous vapeur d'eau (T = 1000 °C).**

**7.1. Mesure de la corrosion.**

On oxyde à 1000 °C pendant 15000 secondes les plaquettes avec substrat de Zircaloy-4 sans revêtement et avec revêtement multicouche Cr/Cr.

La température de 1000 °C se situe dans une gamme qui conduit à une instabilité de la couche de $ZrO_2$ qui peut être formée en surface.

L'évolution au cours du temps de la prise de masse des plaquettes est illustrée par les Figures 20 et 21, ainsi que par le Tableau 6 auquel le graphe de la Figure 22 correspond.

Tableau 6

| Temps d'oxydation (secondes) | Prise de masse (mg/cm$^2$) | |
|---|---|---|
| | Zircaloy-4 sans revêtement | Zircaloy-4 avec revêtement multicouche Cr/Cr |
| 0 | 0 | 0 |
| 5000 | 10,05 | 1,32 |
| 5000 | 10, 68 | 1,22 |
| 7500 | 20,75 | - |
| 15000 | 40,3 | 3, 14 |

Chaque figure fait apparaître une microstructure dans laquelle les couches suivantes se succèdent :

- Figure 20 : couche externe de $ZrO_2$, couche de Zr-$\alpha$(O), substrat de Zircaloy-4 ;
- Figure 21 : couche externe d'or, couche de $Cr_2O_3$, revêtement multicouche Cr/Cr, couche de Zr-$\alpha$(O), substrat de Zircaloy-4.

Ces données font apparaître que la prise de masse issue de la formation d'oxyde est encore fortement limitée par le revêtement multicouche Cr/Cr, même après 15 000 secondes d'oxydation en conditions accidentelles.

Un tel comportement est confirmé par les observations microstructurales, qui montrent une moindre épaisseur de la couche de Zr-$\alpha$(O) pour le substrat de Zircaloy-4 avec revêtement multicouche Cr/Cr (Figure 21), par rapport à celui sans revêtement (Figure 20) qui montre en outre un arrachement partiel de la couche de Zr-$\alpha$(O) au polissage dû à la présence de phase fragile et la formation d'une couche de $ZrO_2$.

Par ailleurs, après 15 000 secondes d'oxydation, les clichés de la surface des plaquettes (non reproduits ici) montrent que seule la surface de la plaquette sans revêtement présente une forte desquamation liée à la faible tenue mécanique de $ZrO_2$. La plaquette avec revêtement multicouche Cr/Cr ne présente quant à elle aucun décollement.

**7.2. Mesure de la prise d'hydrogène.**

Afin de déterminer leur teneur en hydrogène dissous, les plaquettes sont portées à 600 °C afin de dissoudre la totalité des hydrures qui y sont formés.

Par calorimétrie, la teneur en hydrogène est ensuite mesurée par intégration du pic exothermique de précipitation des hydrures après refroidissement.

Les résultats sont regroupés dans le Tableau 7.

Tableau 7

| | Prise de masse après 15000 s | Prise d'hydrogène après 15000 s |
|---|---|---|
| Zircaloy-4 sans revêtement | 40,30 mg/cm$^2$ | 2000 ppm |
| Zircaloy-4 avec revêtement multicouche Cr/Cr | 3,14 mg/cm$^2$ | 200 ppm |

La teneur en hydrogène mesurée montre le gain apporté par le matériau avec revêtement multicouche Cr/Cr pour la résistance à l'hydruration lors d'une oxydation en conditions accidentelles.

## 8. Conclusion.

Les exemples qui précèdent démontrent que le fait de revêtir un substrat à base de zirconium avec un revêtement multicouche selon l'invention comprenant des couches métalliques composées de matières identiques ou différentes choisies parmi le chrome, un alliage de chrome ou un alliage ternaire du système Nb-Cr-Ti présente les avantages suivants :

- en conditions nominales : limiter voire éviter l'oxydation et/ou l'hydruration du substrat à base de zirconium (notamment la formation de la phase fragilisante $ZrO_2$), en particulier lorsque la totalité ou une partie des couches du revêtement multicouche est composée d'un alliage de niobium ;
- en conditions accidentelles, avec ou sans oxydation préalable en conditions nominales : limiter ou éviter la formation de Zr-$\alpha$(O), voir éviter totalement la formation de $ZrO_2$, ces deux oxydes pouvant fragiliser le substrat à base de zirconium ; diminuer la concentration en oxygène dans la couche Zr-ex-$\beta$ afin d'améliorer la ductilité résiduelle et la résistance mécanique du substrat à base de zirconium après oxydation ; et diminuer la prise d'hydrogène pouvant également mener à une fragilisation de la gaine. Il est en particulier à noter que l'utilisation d'un revêtement multicouche au lieu d'un revêtement monocouche de composition identique ou similaire améliore la résistance à l'oxydation du substrat à base de zirconium.

Il découle des avantages précités que l'utilisation d'un matériau multicouche selon l'invention pour fabriquer une gaine de combustible nucléaire à base de zirconium a des conséquences pratiques importantes sur le comportement de cette gaine au cours et à l'issue d'un épisode accidentel, par exemple de type APRP :

- ralentissement de l'oxydation à haute température, afin d'éviter ou du moins retarder un possible emballement de l'oxydation qui conduirait à une dégradation rapide de la gaine associée à une prise ou une production importante d'hydrogène ;
- amélioration de la résistance à l'oxydation à haute température induisant un gain significatif sur les propriétés mécaniques de la gaine, notamment une augmentation de la ductilité résiduelle de la gaine par une meilleure tenue à la trempe et après trempe. Or, la plupart des autorités de sûreté nucléaire dans le monde ont défini un taux d'oxydation critique à ne pas dépasser afin de respecter les marges permettant d'assurer le refroidissement à plus ou moins long terme du coeur d'un réacteur nucléaire après un accident de type l'APRP. L'utilisation du matériau multicouche de l'invention permettrait de gagner des marges au niveau des temps de grâce et températures critiques d'oxydation à respecter. Ceci permet d'envisager des simplifications potentielles des systèmes de sûreté de refroidissement d'urgence et/ou une plus grande souplesse au niveau de la gestion des réacteurs nucléaires ;
- augmentation de la résistance mécanique d'une gaine de combustible nucléaire afin de préserver sa structure lors d'un ballonnement et de gagner des marges de sûreté vis-à-vis de la problématique du taux de bouchage des canaux inter-crayons.

Par ailleurs, hors conditions accidentelles, le matériau multicouche de l'invention a également pour avantages qu'il a un faible impact sur :

- les propriétés mécaniques générales de la gaine en condition de service ;
- le poids des crayons combustibles ;
- le comportement neutronique permettant la mise en oeuvre de revêtements éventuellement un peu capturant ;
- l'utilisation de procédés de dépôt éprouvés facilitant la transposition industrielle ;
- la géométrie actuelle et/ou future des gaines de combustible nucléaire et donc du coeur du réacteur nucléaire. Cela permet d'envisager d'utiliser le matériau multicouche de l'invention dans le coeur de divers types de réacteurs nucléaires (REP, REB, RNR...), pour la propulsion nucléaire, et de manière plus générale, pour tout coeur de réacteur ou chaudière nucléaire, compact ou non, nécessitant une résistance accrue à l'oxydation.

## Revendications

1. Matériau multicouche comprenant un substrat à base de zirconium recouvert d'un revêtement multicouche, ledit revêtement multicouche comprenant de 2 à 50 couches métalliques séquentielles qui sont composées de matières différentes et présentent chacune une épaisseur de 3 nm à 1 $\mu$m, les matières différentes étant choisies parmi le chrome, un alliage de chrome ou un alliage ternaire du système Nb-Cr-Ti.

2. Matériau multicouche obtenu ou susceptible d'être obtenu par le procédé de fabrication selon l'une quelconque des revendications 16 à 22 dans l'alternative selon laquelle les couches métalliques sont composées de matières identiques, lesdites couches métalliques étant au nombre de 2 à 50 et présentant chacune une épaisseur de 3 nm à 1 $\mu$m.

3. Matériau multicouche selon la revendication 1 ou 2, ledit revêtement multicouche consistant en lesdites couches métalliques composées de matières identiques ou différentes choisies parmi le chrome, un alliage de chrome ou un alliage ternaire du système Nb-Cr-Ti.

4. Matériau multicouche selon l'une quelconque des revendications précédentes, dans lequel l'épaisseur cumulée desdites couches métalliques est de 6 nm à 10 $\mu$m.

5. Matériau multicouche selon la revendication 4, dans lequel ledit revêtement multicouche comprend au moins dix couches métalliques dont chacune présente une épaisseur d'au moins 100 nm, l'épaisseur cumulée desdites couches métalliques étant de 1 $\mu$m à 6 $\mu$m.

6. Matériau multicouche selon l'une quelconque des revendications précédentes, dans lequel lesdites couches métalliques composées de chrome ou d'un alliage de chrome contiennent au moins un élément chimique choisi parmi le silicium ou l'yttrium.

7. Matériau multicouche selon la revendication 6, dans lequel le silicium ou l'yttrium est présent à une teneur de 0,1 % à 20 % en atome.

8. Matériau multicouche selon l'une quelconque des revendications précédentes, dans lequel l'alliage ternaire du système Nb-Cr-Ti comprend en atome de 50 % à 75 % de niobium, de 5 % à 15 % de chrome et de 20 % à 35 % de titane.

9. Matériau multicouche selon l'une quelconque des revendications précédentes, dans lequel la ou lesdites couches métalliques composées d'un alliage ternaire du système Nb-Cr-Ti présentent une épaisseur de 5 nm à 500 nm.

10. Matériau multicouche selon l'une quelconque des revendications précédentes à l'exception de la revendication 2, dans lequel lesdites couches métalliques composées de matières différentes sont i) une ou plusieurs couches composées de chrome et/ou d'un alliage de chrome et ii) une ou plusieurs couches composées de l'alliage ternaire du système Nb-Cr-Ti.

11. Matériau multicouche selon la revendication 10, dans lequel une couche métallique intermédiaire d'accrochage composée de chrome ou d'alliage de chrome est en contact avec le substrat à base de zirconium.

12. Matériau multicouche selon l'une quelconque des revendications 2 à 7, dans lequel lesdites couches métalliques composées de matières identiques sont toutes composées de chrome et/ou d'un alliage de chrome.

13. Matériau multicouche selon l'une quelconque des revendications 2 à 5, 8 ou 9, dans lequel lesdites couches métalliques composées de matières identiques sont toutes composées de l'alliage ternaire du système Nb-Cr-Ti.

14. Pièce composée en tout ou partie du matériau multicouche tel que défini selon l'une quelconque des revendications 1 à 13, ladite pièce étant constitutive d'un réacteur nucléaire.

15. Pièce selon la revendication 14, ladite pièce étant une gaine de combustible nucléaire, un tube guide, une grille d'espacement ou un combustible à plaque.

16. Procédé de fabrication d'un matériau multicouche tel que défini selon l'une quelconque des revendications 1 à 13, comprenant une étape dans laquelle on recouvre un substrat à base de zirconium avec un revêtement multicouche comprenant de 2 à 50 couches métalliques qui présentent chacune une épaisseur de 3 nm à 1 $\mu$m et telles que :

   - lesdites couches métalliques sont composées de matières identiques et déposées avec un dépôt séquencé choisi parmi une opération de dépôt physique en phase vapeur (PVD), de dépôt chimique en phase vapeur (CVD) ou d'électrodéposition au cours duquel lesdites couches métalliques sont déposées les unes après les autres, ou

- lesdites couches métalliques sont composées de matières différentes,

les matières identiques ou différentes étant choisies parmi le chrome, un alliage de chrome ou un alliage ternaire du système Nb-Cr-Ti.

17. Procédé de fabrication selon la revendication 16, dans lequel, lorsque lesdites couches métalliques sont composées de matières différentes, on recouvre le substrat en effectuant un dépôt séquencé.

18. Procédé de fabrication selon la revendication 16 ou 17, dans lequel le dépôt séquencé est effectué à une température au maximum de 580 °C.

19. Procédé de fabrication selon l'une quelconque des revendications 17 ou 18, dans lequel on recouvre le substrat à l'aide d'une opération de dépôt chimique en phase vapeur, d'une opération de dépôt physique en phase vapeur ou d'électrodéposition.

20. Procédé de fabrication selon l'une quelconque des revendications 16 à 19, dans lequel l'opération de dépôt physique en phase vapeur est une pulvérisation cathodique.

21. Procédé de fabrication selon la revendication 20, dans lequel la pulvérisation cathodique est de type magnétron.

22. Procédé de fabrication selon l'une quelconque des revendications 16 à 21, dans lequel le dépôt physique en phase vapeur est réalisé à une température de 50 °C à 700 °C.

**Patentansprüche**

1. Mehrschichtiges Material, das ein Substrat auf Zirkoniumbasis umfasst, das mit einer mehrschichtigen Beschichtung bedeckt ist, wobei die mehrschichtige Beschichtung 2 bis 50 sequentielle metallische Schichten umfasst, die aus unterschiedlichen Materialien bestehen und jeweils eine Dicke von 3 nm bis 1 $\mu$m aufweisen, wobei die unterschiedlichen Materialien aus Chrom, einer Chromlegierung oder einer ternären Legierung des Systems Nb-Cr-Ti ausgewählt sind.

2. Mehrschichtiges Material, das durch das Herstellungsverfahren nach einem der Ansprüche 16 bis 22 erhalten wird oder erhalten werden kann, wobei die Schichten alternativ aus identischen Materialien bestehen, wobei die Anzahl der metallischen Schichten 2 bis 50 beträgt und jede eine Dicke von 3 nm bis 1 $\mu$m aufweist.

3. Mehrschichtiges Material nach Anspruch 1 oder 2, wobei die mehrschichtige Beschichtung aus den metallischen Schichten besteht, die aus identischen oder unterschiedlichen Materialien bestehen, ausgewählt aus Chrom, einer Chromlegierung oder einer ternären Legierung des Systems Nb-Cr-Ti.

4. Mehrschichtiges Material nach einem der vorhergehenden Ansprüche, wobei die kumulierte Dicke der metallischen Schichten 6 nm bis 10 $\mu$m beträgt.

5. Mehrschichtiges Material nach Anspruch 4, wobei die mehrschichtige Beschichtung mindestens zehn metallische Schichten umfasst, wovon jede eine Dicke von mindestens 100 nm aufweist, wobei die kumulierte Dicke der metallischen Schichten 1 $\mu$m bis 6 $\mu$m beträgt.

6. Mehrschichtiges Material nach einem der vorhergehenden Ansprüche, wobei die metallischen Schichten, die aus Chrom oder einer Chromlegierung bestehen, mindestens ein chemisches Element enthalten, das aus Silicium oder Yttrium ausgewählt ist.

7. Mehrschichtiges Material nach Anspruch 6, wobei das Silicium oder das Yttrium mit einem Gehalt von 0,1 Atom-% bis 20 Atom-% vorliegt.

8. Mehrschichtiges Material nach einem der vorhergehenden Ansprüche, wobei die ternäre Legierung des Systems Nb-Cr-Ti 50 Atom-% bis 75 Atom-% Niob, 5 Atom-% bis 15 Atom-% Chrom und 20 Atom-% bis 35 Atom-% Titan umfasst.

9. Mehrschichtiges Material nach einem der vorhergehenden Ansprüche, wobei die metallische(n) Schicht(en), die aus einer ternären Legierung des Systems Nb-Cr-Ti bestehen, eine Dicke von 5 nm bis 500 nm aufweisen.

10. Mehrschichtiges Material nach einem der vorhergehenden Ansprüche mit Ausnahme von Anspruch 2, wobei die metallischen Schichten, die aus unterschiedlichen Materialien bestehen, i) eine oder mehrere Schichten sind, die aus Chrom und/oder einer Chromlegierung bestehen, und ii) eine oder mehrere Schichten, die aus der ternären Legierung des Nb-Cr-Ti-Systems bestehen.

11. Mehrschichtiges Material nach Anspruch 10, wobei eine metallische Zwischenverbindungsschicht, die aus Chrom oder einer Chromlegierung besteht, mit dem Substrat auf Zirkoniumbasis in Kontakt steht.

12. Mehrschichtiges Material nach einem der Ansprüche 2 bis 7, wobei die metallischen Schichten aus identischen Materialien alle aus Chrom und/oder einer Chromlegierung bestehen.

13. Mehrschichtiges Material nach einem der Ansprüche 2 bis 5, 8 oder 9, wobei die metallischen Schichten aus identischen Materialien alle aus der ternären Legierung des Systems Nb-Cr-Ti bestehen.

14. Teil, das ganz oder teilweise aus dem mehrschichtigen Material nach einem der Ansprüche 1 bis 13 besteht, wobei das Teil Bestandteil eines Kernreaktors ist.

15. Teil nach Anspruch 14, wobei das Teil eine Kernbrennstoffhülle, ein Führungsrohr, ein Abstandsgitter oder ein plattenförmiger Brennstoff ist.

16. Herstellungsverfahren eines mehrschichtigen Materials nach einem der Ansprüche 1 bis 13, das einen Schritt umfasst, in dem ein Substrat auf Zirkoniumbasis mit einer mehrschichtigen Beschichtung bedeckt wird, die 2 bis 50 metallische Schichten umfasst, die jeweils eine Dicke von 3 nm bis 1 μm aufweisen, und sodass:

    - die metallischen Schichten aus identischen Materialien bestehen und mit einer sequenzierten Abscheidung abgeschieden werden, ausgewählt aus einem Vorgang einer physikalischen Gasphasenabscheidung (PVD), einer chemischen Gasphasenabscheidung (CVD) oder einer Elektroabscheidung, wobei die metallischen Schichten eine nach der anderen abgeschieden werden, oder
    - die metallischen Schichten aus unterschiedlichen Materialien bestehen,

    wobei die identischen oder unterschiedlichen Materialien aus Chrom, einer Chromlegierung oder einer ternären Legierung des Systems Nb-Cr-Ti ausgewählt sind.

17. Herstellungsverfahren nach Anspruch 16, wobei, wenn die metallischen Schichten aus unterschiedlichen Materialien bestehen, das Substrat durch Durchführen einer sequenzierten Abscheidung bedeckt wird.

18. Herstellungsverfahren nach Anspruch 16 oder 17, wobei die sequenzierte Abscheidung bei einer Höchsttemperatur von 580 °C durchgeführt wird.

19. Herstellungsverfahren nach einem der Ansprüche 17 oder 18, wobei das Substrat mit Hilfe eines chemischen Gasphasenabscheidungsvorgangs, eines physikalischen Gasphasenabscheidungs- oder Elektroabscheidungsvorgangs bedeckt wird.

20. Herstellungsverfahren nach einem der Ansprüche 16 bis 19, wobei der physikalische Gasphasenabscheidungsvorgang eine Kathodenzerstäubung ist.

21. Herstellungsverfahren nach Anspruch 20, wobei die Kathodenzerstäubung vom Magnetrontyp ist.

22. Herstellungsverfahren nach einem der Ansprüche 16 bis 21, wobei die physikalische Gasphasenabscheidung bei einer Temperatur von 50 °C bis 700 °C durchgeführt wird.

**Claims**

1. Multilayer material comprising a zirconium-based substrate covered with a multilayer coating, said multilayer coating comprising from 2 to 50 sequential metallic layers composed of different substances and each having a thickness from 3 nm to 1 $\mu$m, the different substances being chosen from chromium, a chromium alloy or a ternary alloy of the Nb-Cr-Ti system.

2. Multilayer material obtained or obtainable by the method of manufacture according to any one of claims 16 to 22 in the alternative in which the metallic layers are composed of identical substances, said metallic layers being from to 2 to 50 in number and each having a thickness from 3 nm to 1 pm.

3. Multilayer material according to claim 1 or 2, said multilayer coating consisting of said metallic layers composed of identical or different substances chosen from chromium, a chromium alloy or a ternary alloy of the Nb-Cr-Ti system.

4. Multilayer material according to any one of the preceding claims, wherein the cumulative thickness of said metallic layers is from 6 nm to 10 pm.

5. Multilayer material according to claim 4, wherein said multilayer coating comprises at least ten metallic layers each of which has a thickness of at least 100 nm, the cumulative thickness of said metallic layers being from 1 pm to 6 pm.

6. Multilayer material according to any one of the preceding claims, wherein said metallic layers composed of chromium or of a chromium alloy contain at least one chemical element chosen from silicon or yttrium.

7. Multilayer material according to claim 6, wherein silicon or yttrium is present at a content of from 0.1 to 20 at%.

8. Multilayer material according to any one of the preceding claims, wherein the ternary alloy of the Nb-Cr-Ti system comprises in atomic percentage from 50% to 75% of niobium, from 5% to 15% of chromium and from 20% to 35% of titanium.

9. Multilayer material according to any one of the preceding claims, wherein said metallic layer or layers composed of a ternary alloy of the Nb-Cr-Ti system have a thickness from 5 nm to 500 nm.

10. Multilayer material according to any one of the preceding claims except claim 2, wherein said metallic layers composed of different substances are i) one or more layers composed of chromium and/or a chromium alloy and ii) one or more layers composed of the ternary alloy of the Nb-Cr-Ti system.

11. Multilayer material according to claim 10, wherein a metallic intermediate bonding layer composed of chromium or of chromium alloy is in contact with the zirconium-based substrate.

12. Multilayer material according to any one of claims 2 to 7, wherein said metallic layers composed of identical substances are all composed of chromium and/or a chromium alloy.

13. Multilayer material according to any one of claims 2 to 5, 8 or 9, wherein said metallic layers composed of identical substances are all composed of the ternary alloy of the Nb-Cr-Ti system.

14. Part composed wholly or partly of the multilayer material as defined according to any one of claims 1 to 13, said part being a component of a nuclear reactor.

15. Part according to claim 14, said part being a nuclear fuel cladding, a guide tube, a spacer grid or a plate fuel.

16. Method for manufacturing a multilayer material as defined according to any one of claims 1 to 13, comprising a step in which a zirconium-based substrate is covered with a multilayer coating comprising from 2 to 50 metallic layers which each has a thickness from 3 nm to 1 pm and such that:

   - said metallic layers are composed of identical substances and deposited with a sequential deposition using chosen form an operation of physical vapor deposition (PVD), chemical vapor deposition (CVD) or electrodeposition during which said metallic layers are deposited one after another, or
   - said metallic layers are composed of different substances,

the identical or different substances being chosen from chromium, a chromium alloy or a ternary alloy of the Nb-Cr-Ti system.

17. Method of manufacture according to claim 16, wherein, when said metallic layers are composed of different substances, the substrate is covered by performing sequential deposition.

18. Method of manufacture according to claim 16 or 17, wherein the sequential deposition is carried out at a temperature of at most 580°C.

19. Method of manufacture according to any one of claims 17 to 18, wherein the substrate is covered by means of an operation of chemical vapor deposition, of an operation of physical vapor deposition or of pulsed electrolysis.

20. Method of manufacture according to any one of claims 16 to 19, wherein the operation of physical vapor deposition is cathodic sputtering.

21. Method of manufacture according to claim 20, wherein the cathodic sputtering is of the magnetron type.

22. Method of manufacture according to any one of claims 16 to 21, wherein physical vapor deposition is carried out at a temperature of from 50°C to 700°C.

**FIG. 1**

**FIG. 2**

**FIG. 3**

**FIG. 4**

**FIG. 5**

**FIG. 6**

EP 2 841 264 B1

**FIG. 7**

**FIG. 8**

Cr/Nb-Cr-Ti en partie oxydé

Zr-α(O)

Zircaloy-4

**FIG. 9**

Au

Cr/Nb-Cr-Ti en partie oxydé

Zr-α(O)

Zircaloy-4

**FIG. 10**

Cr en partie oxydé

Zr-α(O)

Zircaloy-4

**FIG. 11**

$Cr_2O_3$

Cr/Cr

Zircaloy-4

**FIG. 12**

ZrO$_2$

Zircaloy-4

**FIG. 13**

ZrO$_2$

Zr-α(O)

Zircaloy-4

**FIG. 14**

**FIG. 15**

**FIG. 16**

Cr$_2$O$_3$
Cr/Cr
Zircaloy-4

**FIG. 17**

Cr$_2$O$_3$
Cr/Cr
ZrO$_2$
Zr-α(O)
Zircaloy-4

**FIG. 18**

FIG. 19

EP 2 841 264 B1

**FIG. 20**

**FIG. 21**

**FIG. 22**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

* FR 1493040 A

**Littérature non-brevet citée dans la description**

* **D.L. DAVIDSON ; K.S. CHAN ; D.L. ANTON.** The Effects on Fracture Toughness of Ductile-Phase composition and Morphology in Nb-Cr-Ti and Nb-Si In Situ Composites. *METALLURGICAL AND MATERIALS TRANSACTIONS A,* 1996, vol. 27A, 3007-3018